# EUROPEAN PATENT SPECIFICATION

(11) **EP 3 020 782 B1**
(45) Date of publication and mention of the grant of the patent: **01.08.2018**
(21) Application number: 14192661.8
(22) Date of filing: 11.11.2014
(51) Int. Cl.: C09K 11/06, H01L 51/50

(54) **An electroluminescent compound and an electroluminescent device comprising the same**
Elektrolumineszierende Verbindung und Elektrolumineszenzvorrichtung damit
Composés électroluminescents et dispositif électroluminescent les utilisant

(43) Date of publication of application: 18.05.2016
(73) Proprietor: SFC Co., Ltd., Chungcheongbuk-do (KR)
(72) Inventor: Kim, Jeong-Soo, Chungcheongnam-do (KR); Ryu, Yeon-Kwon, Chungcheongbuk-do (KR); Ko, Sang-Won, Incheon (KR); Lee, Su-Jin, Busan (KR); Kim, Ji-Young, Gyeongsangbuk-do (KR); Kim, Ji-Hwan, Gyeonggi-do (KR)
(74) Representative: V.O.

(56) References cited:
- EP-A1- 2 796 529
- WO-A1-2006/033564
- WO-A1-2006/080640
- KR-A- 20110 109 687
- US-A1- 2011 278 549
- HONG-JI JIANG ET AL: "Synthesis and characterization of novel topology-varied compounds based on fluorene and carbazole: Potential host materials for phosphorescent organic light-emitting diodes", SYNTHETIC METALS, vol. 197, 5 October 2014 (2014-10-05), pages 217-224, XP055191952, ISSN: 0379-6779, DOI: 10.1016/j.synthmet.2014.09.014
- CHEN HUA ET AL: "Spiro-annulated hole-transport material outperforms NPB with higher mobility and stability in organic light-emitting diodes", DYES AND PIGMENTS, vol. 107, 21 March 2014 (2014-03-21), pages 15-20, XP028659824, ISSN: 0143-7208, DOI: 10.1016/J.DYEPIG.2014.03.006
- YE-XIN ZHANG ET AL: "Control of Conjugation Degree via Position Engineering to Highly Efficient Phosphorescent Host Materials", ORGANIC LETTERS, vol. 16, no. 14, 18 July 2014 (2014-07-18) , pages 3748-3751, XP055192028, ISSN: 1523-7060, DOI: 10.1021/ol501603b
- HIROSHI OHKUMA ET AL: "Thermally Activated Delayed Fluorescence from a Spiro-diazafluorene Derivative", CHEMISTRY LETTERS, vol. 43, no. 7, 1 January 2014 (2014-01-01), pages 1017-1019, XP055192030, ISSN: 0366-7022, DOI: 10.1246/cl.140360
- SHOU-CHENG DONG ET AL: "Spiro-annulated triarylamine-based hosts incorporating dibenzothiophene for highly efficient single-emitting layer white phosphorescent organic light-emitting diodes", JOURNAL OF MATERIALS CHEMISTRY C, vol. 1, no. 40, 1 January 2013 (2013-01-01), page 6575, XP055192026, ISSN: 2050-7526, DOI: 10.1039/c3tc31336k

## Description

### BACKGROUND OF THE INVENTION

### 1. Field of the Invention

The present invention relates to organic electroluminescence devices including organic light emitting compounds that have excellent luminescent properties such as high power efficacy and luminance.

### 2. Description of the Related Art

Materials for organic layers of organic light emitting devices can be classified into light emitting materials and charge transport materials by their functions. The charge transport materials are classified into hole injecting materials, hole transport materials, electron transport materials, and electron injecting materials depending on what they transport or inject. The light emitting materials are classified into blue, green, and red light emitting materials by their colors. The light emitting materials also include yellow and orange light emitting materials necessary to obtain more natural colors.

A host/dopant system can be used as a light emitting material to increase the color purity of a light emitting layer and achieve increased luminescence efficiency of the light emitting layer through energy transfer. The host/dopant system is based on the principle that when a small amount of a dopant having a smaller energy bandgap than a host constituting the light emitting layer and high luminescence efficiency is mixed in the light emitting layer, excitons generated from the host are transported to the dopant to emit light with high efficiency. During this process, the wavelength of the host is shifted to the wavelength band of the dopant. Therefore, light with a desired wavelength can be obtained depending on the kind of the dopant used.

Stability and efficiency of materials for organic layers are prerequisites for the fabrication of organic light emitting devices with excellent characteristics. That is, organic light emitting devices should be supported by stable, efficient materials for organic layers, for example, hole injecting layers, hole transport layers, light emitting layers, electron transport layers, and electron injecting layers, for their excellent characteristics. However, organic layer materials for stable, efficient organic light emitting devices still remain at the early stage of development. There is thus a continued need to develop novel materials for organic layers of organic light emitting devices.

Hong-ji Jiang et al., Synthetic Metals vol. 197 (2014), pages 217-224 is directed to the synthesis and characterization of topology-varied compounds based on fluorene and carbazole. It describes phosphorescent organic light-emitting diodes (PHOLEDs) based on 2CSFO.

### SUMMARY OF THE INVENTION

The invention is directed to an organic electroluminescence device comprising a first electrode, a second electrode opposite the first electrode, and an organic layer interposed between the first electrode and the second electrode, wherein the organic layer comprises a compound as defined in claim 1.

The disclosure is further directed to providing organic light emitting compounds that can be used to fabricate organic electroluminescence devices with improved luminescent properties. The present invention is also directed to providing organic electroluminescence devices including the organic light emitting compounds that have excellent luminescent properties such as high power efficacy and luminance.

According to one aspect of the disclosure, an organic electroluminescence device is provided which includes an organic layer including one or more organic light emitting compounds represented by Formula I:

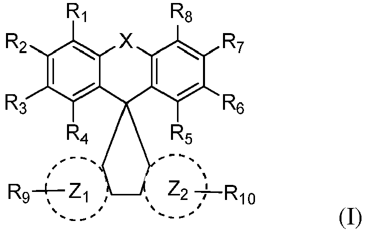

According to the present invention, the compound of Formula I is a compound selected from compounds 1-5 and 7-62 as defined in the claims.

According to another aspect of the present invention, an organic electroluminescence device is provided which includes an organic layer including one or more organic light emitting compounds selected from compounds 1-5 and 7-62 as defined in claim 1,; and
one or more organic light emitting compounds represented by Formula II:

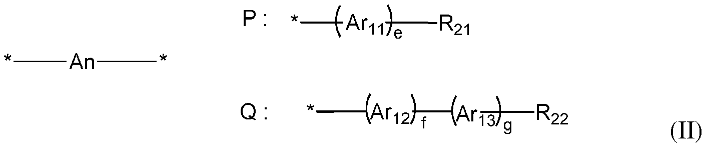

The organic electroluminescence devices of the present invention can be driven at low voltages to achieve high power efficacy. In addition, the organic electroluminescence devices of the present invention have excellent luminescent properties such as high luminance and luminous efficiency. Due to these advantages, the organic electroluminescence devices of the present invention can be utilized as various display devices and lighting devices.

### BRIEF DESCRIPTION OF THE DRAWINGS

These and/or other aspects and advantages of the invention will become apparent and more readily appreciated from the following description of the embodiments, taken in conjunction with the accompanying drawings of which:

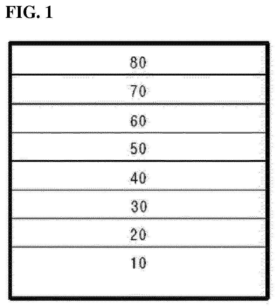

FIG. 1 is a schematic view of an organic electroluminescence device according to one embodiment of the present invention.

### DETAILED DESCRIPTION OF THE INVENTION

The present invention will now be described in more detail.

The present invention relates to organic electroluminescence devices with improved luminescent properties such as high power efficacy and luminance which include an organic layer including novel organic light emitting compounds. The organic light emitting compounds present in the device according to the invention are as defined in claim 1. Also described herein are organic light emitting compounds represented by Formula I: 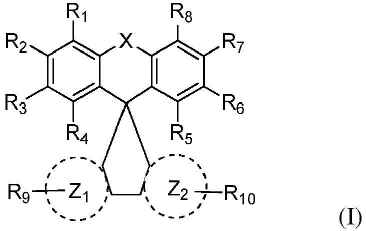 wherein X is NR₁₁, O, S or SiR₁₂R₁₃, Z₁ and Z₂ may be identical to or different from each other and may be each independently selected from monocyclic or polycyclic aromatic rings, monocyclic or polycyclic heteroaromatic rings, 5- and 6-membered heteroaromatic rings fused with an aromatic ring, and monocyclic or polycyclic aromatic rings fused with a 5- or 6-membered heteroaromatic ring, R₁ to R₁₃ may be identical to or different from each other and may be each independently selected from hydrogen, deuterium, substituted or unsubstituted C₁-C₃₀ alkyl groups, substituted or unsubstituted C₅-C₅₀ aryl groups, substituted or unsubstituted C₂-C₃₀ alkenyl groups, substituted or unsubstituted C₂-C₂₀ alkynyl groups, substituted or unsubstituted C₃-C₃₀ cycloalkyl groups, substituted or unsubstituted C₂-C₅₀ heteroaryl groups containing one or more heteroatoms selected from O, N, S, and P, substituted or unsubstituted C₁-C₃₀ alkoxy groups, substituted or unsubstituted C₆-C₃₀ aryloxy groups, substituted or unsubstituted C₁-C₃₀ alkylthioxy groups, substituted or unsubstituted C₅-C₃₀ arylthioxy groups, substituted or unsubstituted C₁-C₃₀ alkylamine groups, substituted or unsubstituted C₅-C₃₀ arylamine groups, substituted or unsubstituted C₁-C₃₀ alkylsilyl groups, substituted or unsubstituted C₅-C₃₀ arylsilyl groups, cyano groups, nitro groups, hydroxyl groups, and halogen groups, and R₁ to R₁₃ each may be optionally linked to the adjacent substituent to form an alicyclic or aromatic monocyclic or polycyclic ring whose carbon atoms may be optionally substituted with one or more heteroatoms selected from N, S, and O and may be optionally further substituted with one or more substituents selected from deuterium, cyano groups, halogen groups, hydroxyl groups, nitro groups, C₁-C₂₄ alkyl groups, C₁-C₂₄ halogenated alkyl groups, C₁-C₂₄ alkenyl groups, C₁-C₂₄ alkynyl groups, C₃-C₂₄ cycloalkyl groups, C₆-C₂₄ aryl groups, C₆-C₂₄ arylalkyl groups, C₂-C₂₄ heteroaryl groups, C₁-C₂₄ alkoxy groups, C₁-C₂₄ alkylamino groups, C₃-C₂₄ arylamino groups, C₁-C₂₄ alkylsilyl groups, C₃-C₂₄ arylsilyl groups, and C₃-C₂₄ aryloxy groups; and
compounds represented by Formula II: 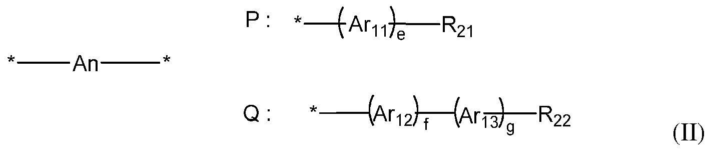 wherein An is a substituted or unsubstituted anthracene moiety, the two asterisks * indicate positions at which An is bonded to P or Q, Ar₁₁, Ar₁₂, and Ar₁₃ are identical to or different from each other and are each independently a single bond, a substituted or unsubstituted C₅-C₅₀ aromatic linking group, or a substituted or unsubstituted C₂-C₆₀ heteroaromatic linking group, R₂₁ and R₂₂ are identical to or different from each other and are each independently selected from hydrogen, deuterium, halogen atoms, hydroxyl groups, cyano groups, nitro groups, amino groups, amidino groups, hydrazine groups, hydrazone groups, carboxylic acid groups and salts thereof, sulfonic acid groups and salts thereof, phosphoric acid groups and salts thereof, substituted or unsubstituted C₁-C₆₀ alkyl groups, substituted or unsubstituted C₂-C₆₀ alkenyl groups, substituted or unsubstituted C₂-C₆₀ alkynyl groups, substituted or unsubstituted C₁-C₆₀ alkoxy groups, substituted or unsubstituted C₁-C₆₀ alkylthio groups, substituted or unsubstituted C₃-C₆₀ cycloalkyl groups, substituted or unsubstituted C₆-C₆₀ aryl groups, substituted or unsubstituted C₅-C₆₀ aryloxy groups, substituted or unsubstituted C₅-C₆₀ arylthio groups, substituted or unsubstituted C₂-C₆₀ heteroaryl groups, substituted or unsubstituted C₁-C₆₀ (alkyl)amino groups, di(substituted or unsubstituted C₁-C₆₀ alkyl)amino groups, (substituted or unsubstituted C₆-C₆₀ aryl)amino groups, di(substituted or unsubstituted C₆-C₆₀ aryl)amino groups, substituted or unsubstituted C₁-C₄₀ alkylsilyl groups, substituted or unsubstituted C₆-C₃₀ arylsilyl groups, germanium, phosphorus, and boron, each of R₂₁, R₂₂, and substituents thereof may optionally form a fused ring with the adjacent group, and e, f, and g are identical to or different from each other and are each independently an integer from 0 to 4.

According to preferred embodiments of Formula (I), 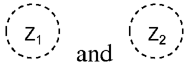 may be identical to or different from each other and may be each independently selected from the following structures C1 to C15: 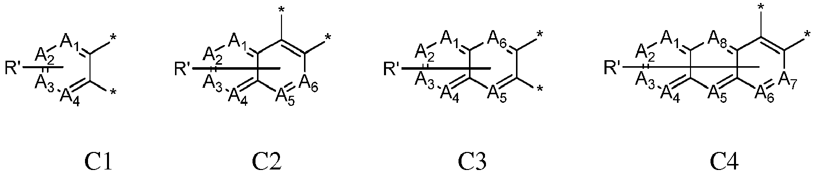 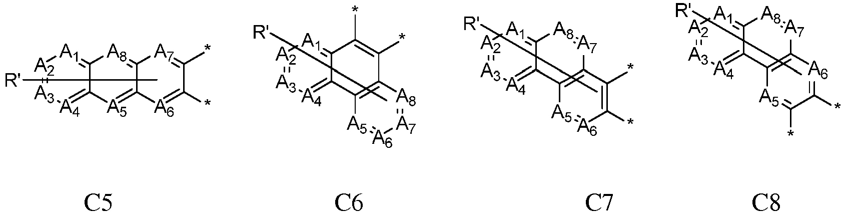 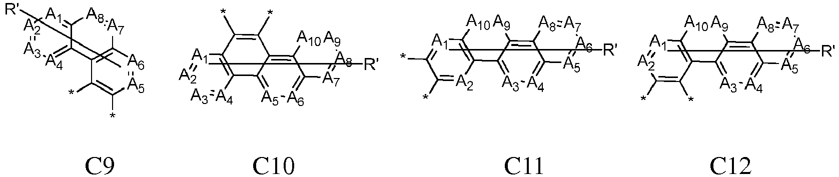 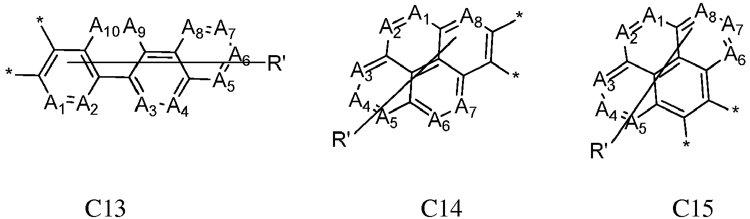 wherein A₁ to A₁₀ are identical to or different from each other and may be each independently N or CR, R and R' are as defined in Formula I, and * indicates a site at which the corresponding structure is bonded to the main skeleton of Formula I.

In Formula I, R₁ to R₁₀ are identical to or different from each other. More specifically, R₁ to R₁₀ may be each independently selected from hydrogen, deuterium, halogens, hydroxyl groups, cyano groups, nitro groups, substituted or unsubstituted C₁-C₂₀ alkyl groups, substituted or unsubstituted C₃-C₃₀ cycloalkyl groups, substituted or unsubstituted C₂-C₂₀ alkenyl groups, substituted or unsubstituted C₂-C₂₀ alkynyl groups, substituted or unsubstituted C₅-C₅₀ aryl groups, substituted or unsubstituted C₂-C₅₀ heteroaryl groups, and the following structure Q: 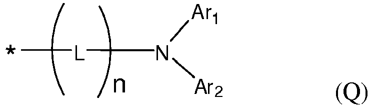 wherein * indicates a site at which the structure is bonded to the main skeleton of Formula I, L may be selected from substituted or unsubstituted C₁-C₆₀ alkylene groups, substituted or unsubstituted C₂-C₆₀ alkenylene groups, substituted or unsubstituted C₂-C₆₀ alkynylene groups, substituted or unsubstituted C₃-C₆₀ cycloalkylene groups, substituted or unsubstituted C₅-C₅₀ arylene groups, substituted or unsubstituted C₂-C₅₀ heteroarylene groups, substituted or unsubstituted C₆-C₆₀ arylene groups fused with one or more substituted or unsubstituted C₃-C₃₀ cycloalkyl groups, and substituted or unsubstituted C₂-C₆₀ heteroarylene groups fused with one or more substituted or unsubstituted C₃-C₃₀ cycloalkyl groups, n is an integer from 0 to 2, provided that when n is 2, the two moieties L may be identical to or different from each other, Ar₁ and Ar₂ may be identical to or different from each other and may be each independently selected from substituted or unsubstituted C₁-C₃₀ alkyl groups, substituted or unsubstituted C₃-C₃₀ cycloalkyl groups, and substituted or unsubstituted C₅-C₅₀ aryl groups, substituted or unsubstituted C₂-C₅₀ heteroaryl groups containing one or more heteroatoms selected from O, N, S, and P, and Ar₁ and Ar₂ may be linked to each other or Ar₁ and Ar₂ each may be linked to the adjacent substituent to form an aliphatic, aromatic, heteroaliphatic or heteroaromatic fused ring.

R₉ and R₁₀ in Formula I may be identical to or different from each other and are each independently the structure Q.

In the structure Q, the amine group 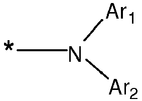 including Ar₁ and Ar₂ may be each independently selected from the following substituents B1 to B46:

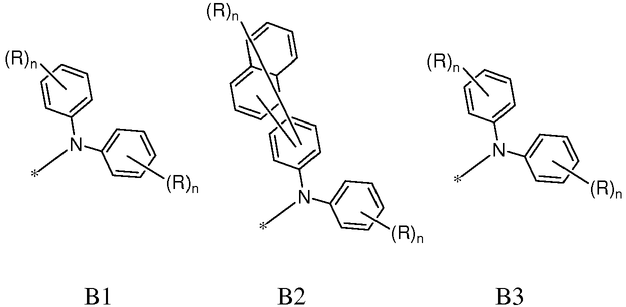

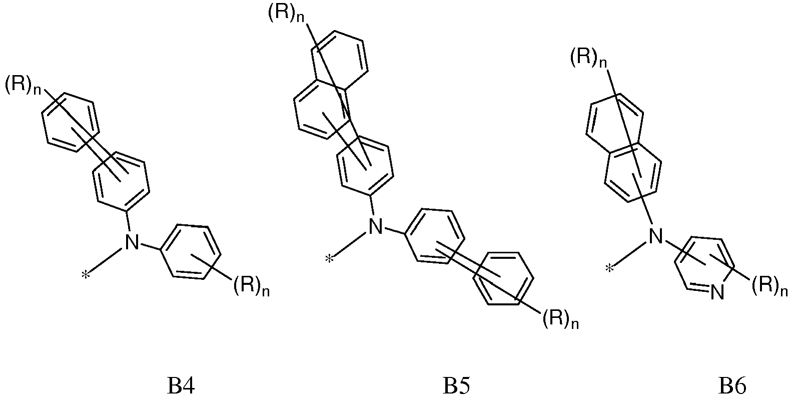

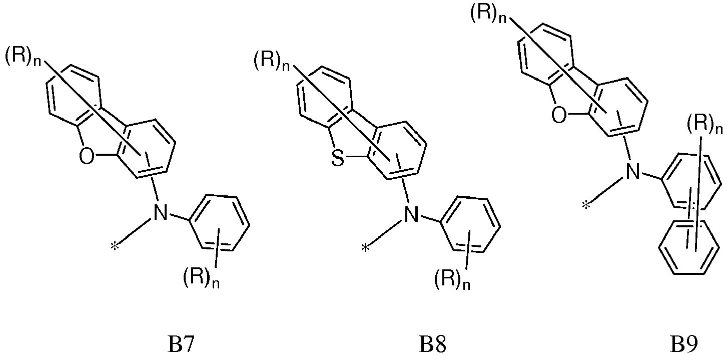

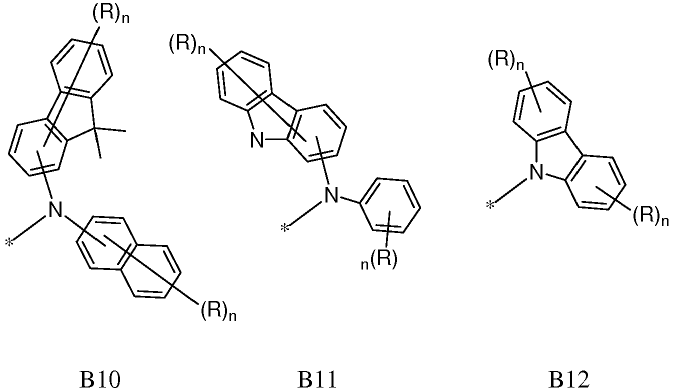

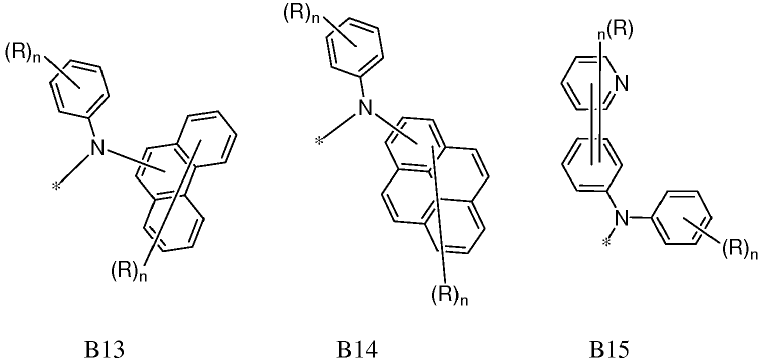

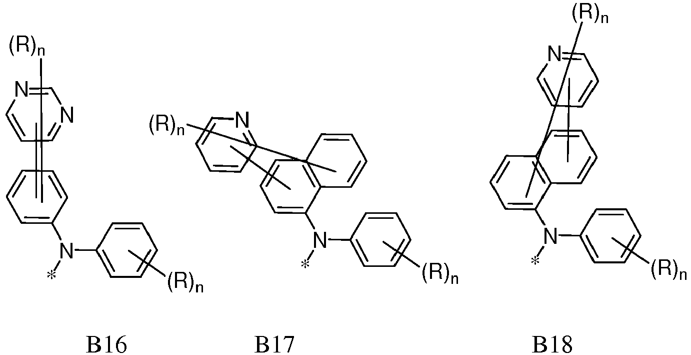

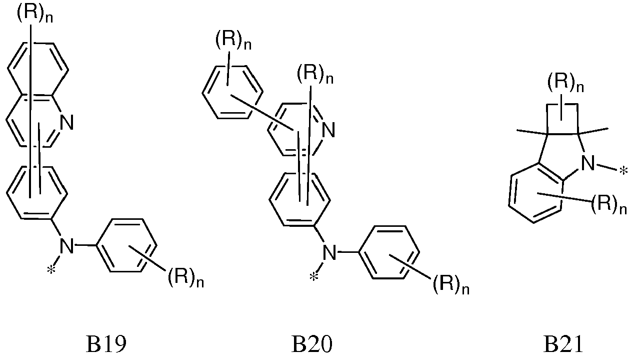

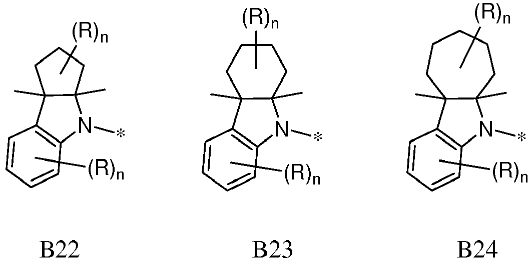

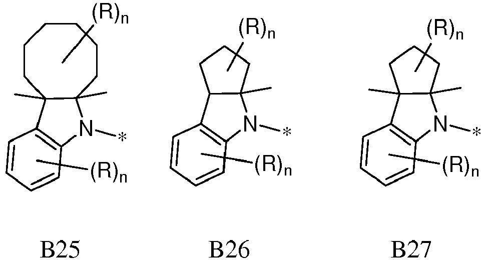

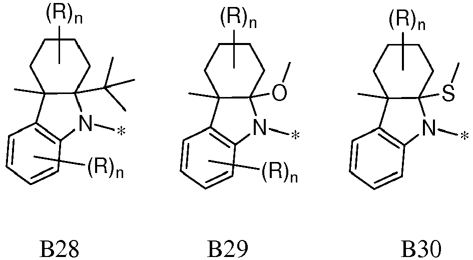

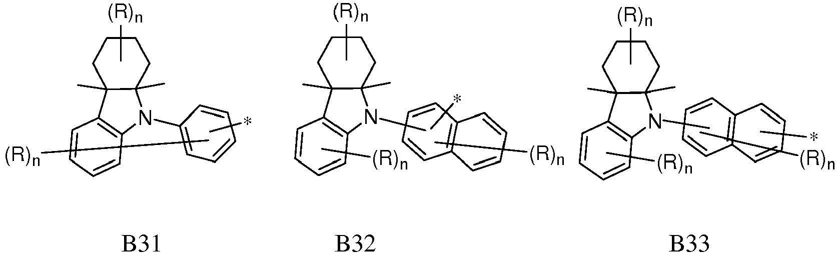

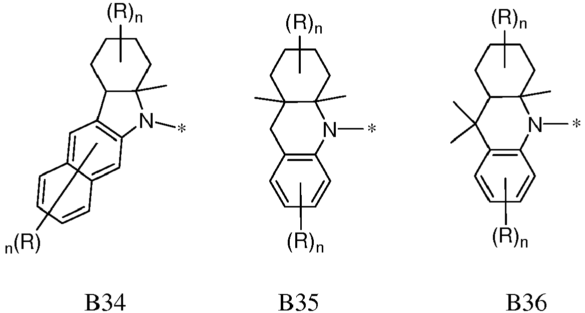

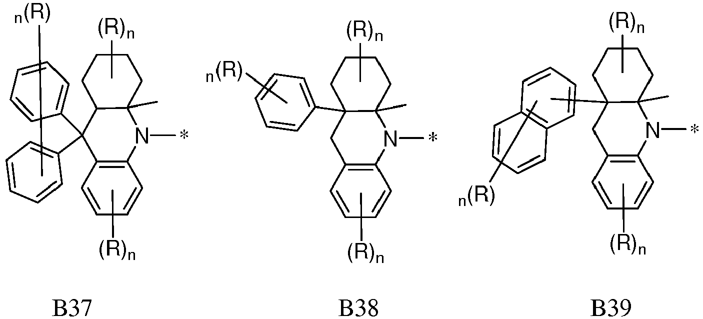

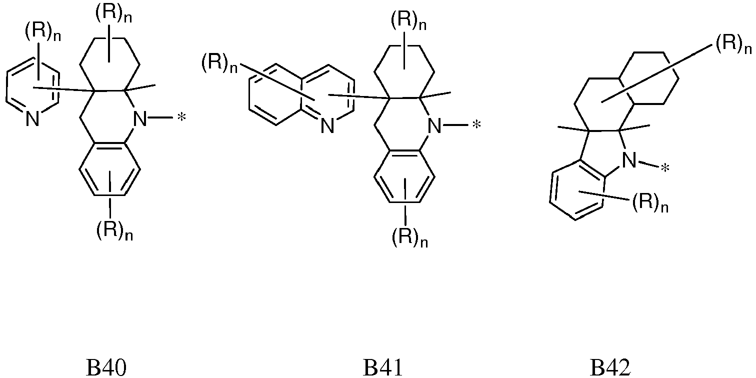

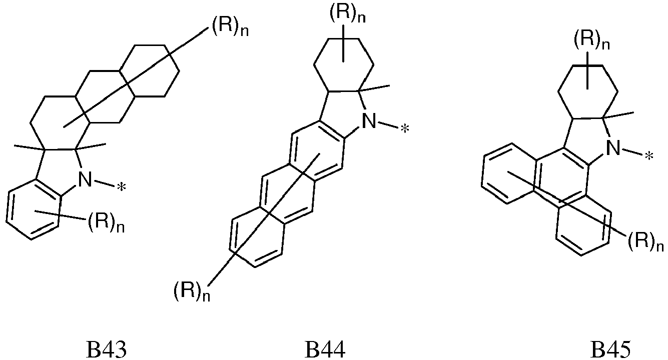

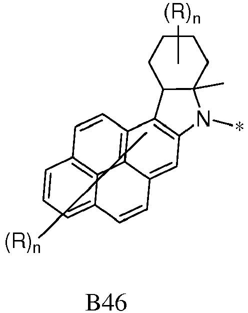

In Substituents B1 to B46, R may be selected from hydrogen, deuterium, cyano groups, halogen groups, C₁-C₆ alkyl groups, C₆-C₁₈ aryl groups, C₆-C₁₈ arylalkyl groups, C₃-C₁₈ heteroaryl groups, C₁-C₁₂ alkylsilyl groups, C₆-C₁₈ arylsilyl groups, substituted or unsubstituted C₁-C₆ alkoxy groups, and substituted or unsubstituted C₆-C₁₈ aryloxy groups, n is an integer from 0 to 12, provided that when n is greater than or equal to 2, the groups R may be identical to or different from each other and may be fused with the adjacent substituent to form a ring.

More specifically, the organic light emitting compounds represented by Formula I may be selected from compounds represented by Formulae A and B: 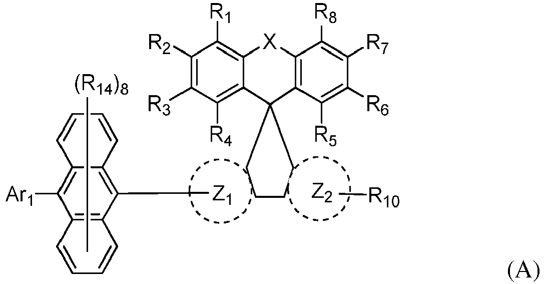 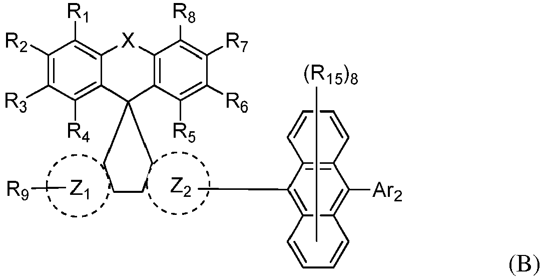 wherein X, Z₁, Z₂, and R₁ to R₁₃ are as defined in Formula I, Ar₁ and Ar₂ may be identical to or different from each other and may be each independently selected from substituted or unsubstituted C₁-C₃₀ alkyl groups, substituted or unsubstituted C₃-C₃₀ cycloalkyl groups, substituted or unsubstituted C₅-C₅₀ aryl groups, and substituted or unsubstituted C₂-C₅₀ heteroaryl groups containing O, N, S or P as a heteroatom, and R₁₄ and R₁₅ have the same meanings as R₁ to R₁₃ defined in Formula I.

More specifically, the organic light emitting compounds of Formula II according to the present invention may be anthracene derivatives selected from Formulae II-1 to II-3: 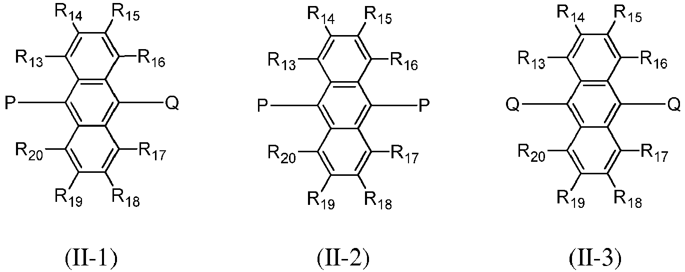 wherein R₁₃ to R₂₀ have the same meanings as R₂₁ and R₂₂ defined in Formula II, and P and Q are as defined in Formula II.

The aryl groups used as substituents in the compounds of the present invention are organic radicals derived from aromatic hydrocarbons by removal of a hydrogen atom. Such aryl groups include 5- to 7-membered, preferably 5- or 6-membered single or fused ring systems. When substituted, the aryl groups may be optionally fused with the adjacent substituent to form a ring.

Specific examples of the aryl groups include aromatic groups, such as phenyl, 2-methylphenyl, 3-methylphenyl, 4-methylphenyl, 4-ethylphenyl, o-biphenyl, m-biphenyl, p-biphenyl, 4-methylbiphenyl, 4-ethylbiphenyl, o-terphenyl, m-terphenyl, p-terphenyl, 1-naphthyl, 2-naphthyl, 1-methylnaphthyl, 2-methylnaphthyl, anthryl, phenanthryl, pyrenyl, indenyl, fluorenyl, tetrahydronaphthyl, perylenyl, crycenyl, naphthacenyl, and fluoranthenyl groups.

At least one hydrogen atom of each aryl group may be substituted with a deuterium atom, a halogen atom, a hydroxyl group, a nitro group, a cyano group, a silyl group, an amino group (-NH₂, -NH(R), -N(R')(R") in which R, R' and R" are each independently a C₁-C₁₀ alkyl group (the -NH(R) and -N(R')(R") are referred to as "alkylamino groups")), an amidino group, a hydrazine group, a hydrazone group, a carboxyl group, a sulfonic acid group, a phosphoric acid group, a C₁-C₂₄ alkyl group, a C₁-C₂₄ halogenated alkyl group, a C₁-C₂₄ alkenyl group, a C₁-C₂₄ alkynyl group, a C₁-C₂₄ heteroalkyl group, a C₆-C₂₄ aryl group, a C₆-C₂₄ arylalkyl group, a C₂-C₂₄ heteroaryl group, or a C₂-C₂₄ heteroarylalkyl group.

The heteroaryl groups used as substituents in the compounds of the disclosure refer to C₂-C₂₄ heteroaromatic organic radicals that may include one to four heteroatoms selected from N, O, P, and S in each ring of the aryl group. The rings may be fused together to form a ring. At least one hydrogen atom of each heteroaryl group may be substituted with the same substituent as in the aryl groups.

Specific examples of the heteroaryl groups include, but are not limited to, pyrrole, furan, thiophene, pyrazole, imidazole, triazole, tetrazole, oxazole, thiazole, indole, carbazole, azacarbazole, benzofuran, dibenzofuran, benzothiophene, dibenzothiophene, indazole, benzimidazole, benzoxazole, benzothiazole, purine, pyridinyl, pyrimidinyl, triazinyl, quinolinyl, quinazolinyl, piperidinyl, morpholidinyl, piperadinyl, phenazinyl, acridinyl, phenathrolinyl, and indenoindole groups.

Specific examples of the alkyl groups as substituents suitable for use in the compounds of the disclosure include methyl, ethyl, propyl, isobutyl, sec-butyl, tert-butyl, pentyl, iso-amyl, hexyl, heptyl, octyl, stearyl, trichloromethyl, and trifluoromethyl groups. At least one hydrogen atom of each alkyl group may be substituted with a deuterium atom, a halogen atom, a hydroxyl group, a nitro group, a cyano group, a trifluoromethyl group, a silyl group (herein referred to as an "alkylsilyl group"), a substituted or unsubstituted amino group (-NH₂, -NH(R) or -N(R')(R"), in which R, R', and R" are each independently a C₁-C₂₄ alkyl group (the -NH(R) and - N(R')(R") are referred to as "alkylamino groups"), an amidino group, a hydrazine group, a hydrazone group, a carboxyl group, a sulfonic acid group, a phosphoric acid group, a C₁-C₂₄ alkyl group, a C₁-C₂₄ halogenated alkyl group, a C₂-C₂₄ alkenyl group, a C₂-C₂₄ alkynyl group, a C₁-C₂₄ heteroalkyl group, a C₅-C₂₄ aryl group, a C₆-C₂₄ arylalkyl group, a C₃-C₂₄ heteroaryl group, or a C₃-C₂₄ heteroarylalkyl group.

Specific examples of the alkoxy groups as substituents suitable for use in the compounds of the disclosure include methoxy, ethoxy, propoxy, isobutyloxy, sec-butyloxy, pentyloxy, iso-amyloxy, and hexyloxy groups. The alkoxy groups may be substituted with the same substituents as in the alkyl groups.

Specific examples of the halogen groups as substituents suitable for use in the compounds of the disclosure include fluoro (F), chloro (Cl), and bromo (Br) groups.

The aryloxy groups used as substituents in the compounds of the disclosure refer to -O-aryl radicals in which the aryl group is as defined above. Specific examples of the aryloxy groups include phenoxy, naphthoxy, anthracenyloxy, phenanthrenyloxy, fluorenyloxy, and indenyloxy. At least one hydrogen atom of each the aryloxy group may be substituted.

Specific examples of the silyl groups as substituents suitable for use in the compounds of the disclosure include trimethylsilyl, triethylsilyl, triphenylsilyl, trimethoxysilyl, dimethoxyphenylsilyl, diphenylmethylsilyl, diphenylvinylsilyl, methylcyclobutylsilyl, and dimethylfurylsilyl.

The alkenyl groups used in the compounds of the disclosure are straight or branched alkenyl groups, and specific examples thereof include 3-pentenyl, 4-hexenyl, 5-heptenyl, 4-methyl-3-pentenyl, 2,4-dimethyl-pentenyl, 6-methyl-5-heptenyl, and 2,6-dimethyl-5-heptenyl groups.

The term "substituted" in the definition of "substituted or unsubstituted" used herein refers to substitution with at least one substituent selected from the group consisting of deuterium, cyano groups, halogen groups, hydroxyl groups, nitro groups, C₁-C₂₄ alkyl groups, C₁-C₂₄ halogenated alkyl groups, C₁-C₂₄ alkenyl groups, C₁-C₂₄ alkynyl groups, C₁-C₂₄ heteroalkyl groups, C₆-C₂₄ aryl groups, C₆-C₂₄ arylalkyl groups, C₂-C₂₄ heteroaryl groups, C₂-C₂₄ heteroarylalkyl groups, C₁-C₂₄ alkoxy groups, C₁-C₂₄ alkylamino groups, C₁-C₂₄ arylamino groups, C₁-C₂₄ heteroarylamino groups, C₁-C₂₄ alkylsilyl groups, C₁-C₂₄ arylsilyl groups, C₁-C₂₄ aryloxy groups, germanium, phosphorus, and boron.

In the "substituted or unsubstituted C₁-C₃₀ alkyl groups", "substituted or unsubstituted C₅-C₅₀ aryl groups", etc., the number of carbon atoms in each substituted or unsubstituted alkyl or aryl group is considered as the number of carbon atoms constituting the unsubstituted alkyl or aryl moiety and the number of carbon atoms in the substituent(s) is excluded therefrom. For example, a phenyl group substituted with a butyl group at the para-position corresponds to a C₆ aryl group substituted with a C₄ butyl group.

According to the present invention, the organic light emitting compounds of Formula I are selected from the following compounds 1-5 and 7-62:

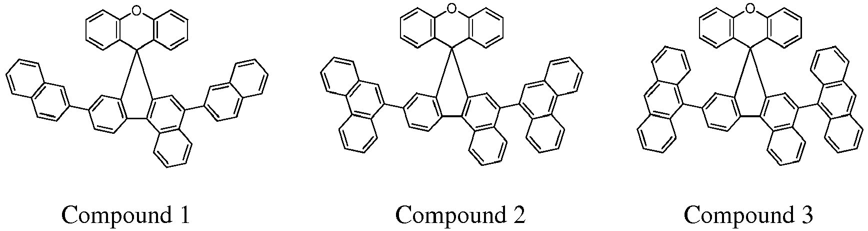

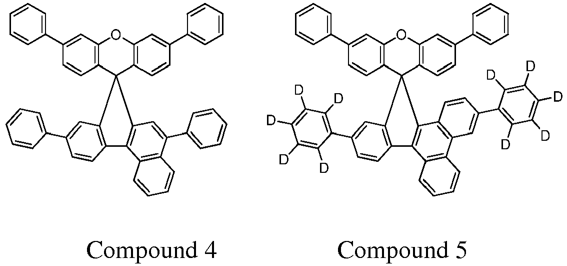

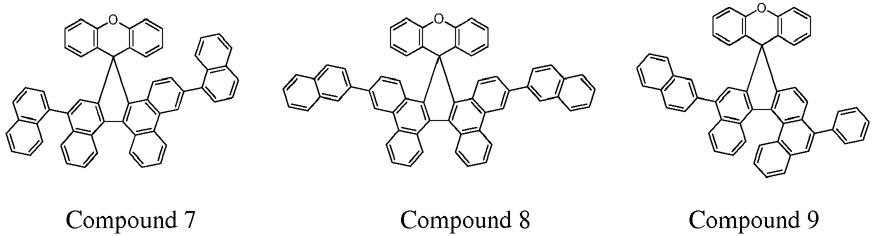

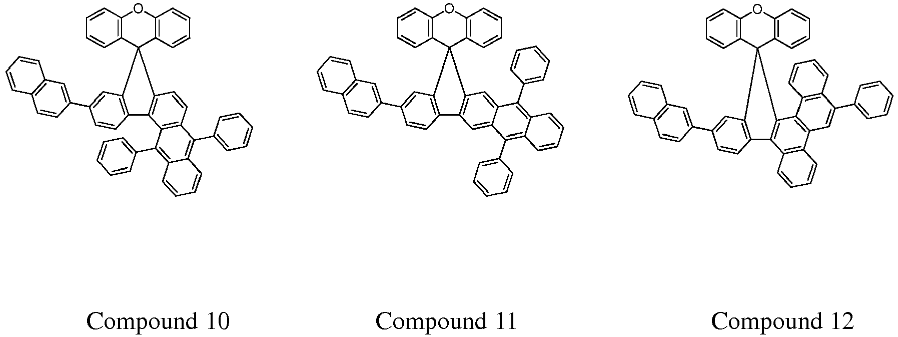

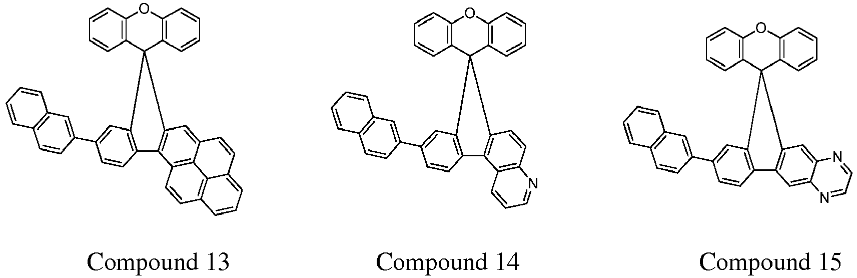

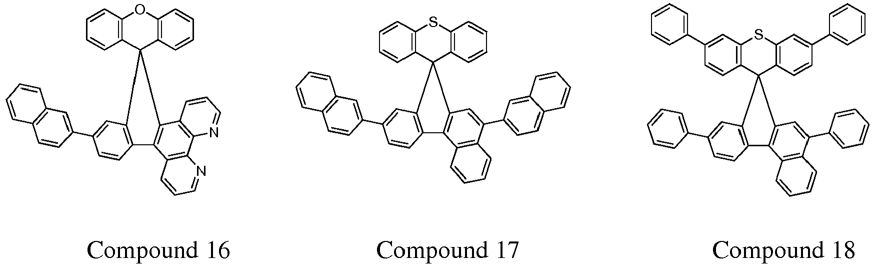

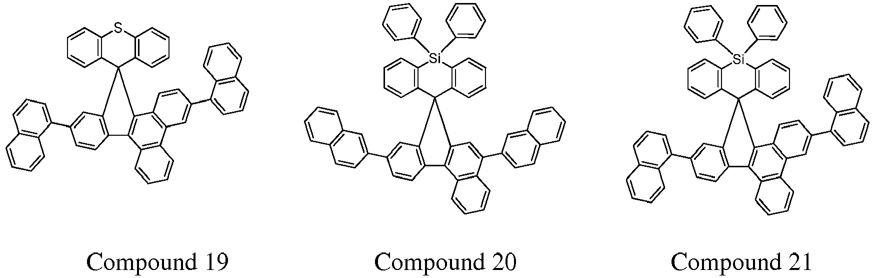

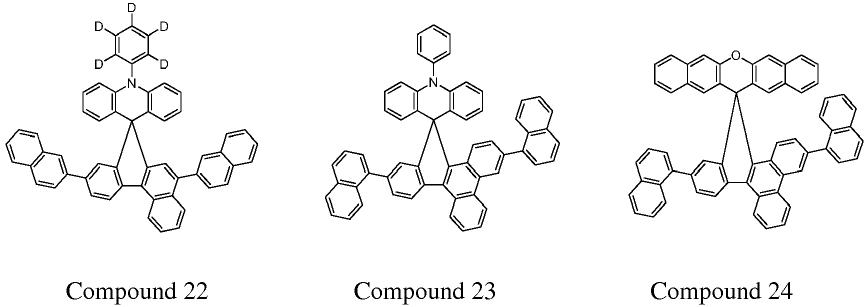

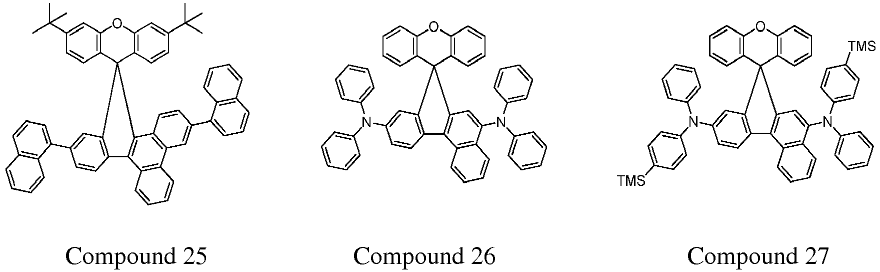

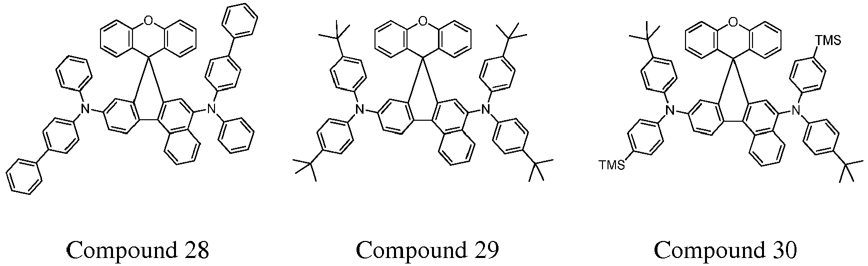

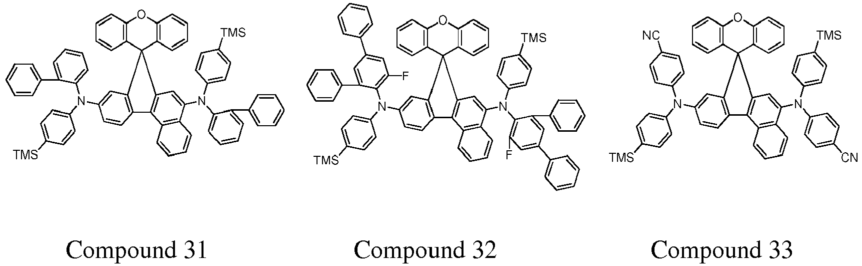

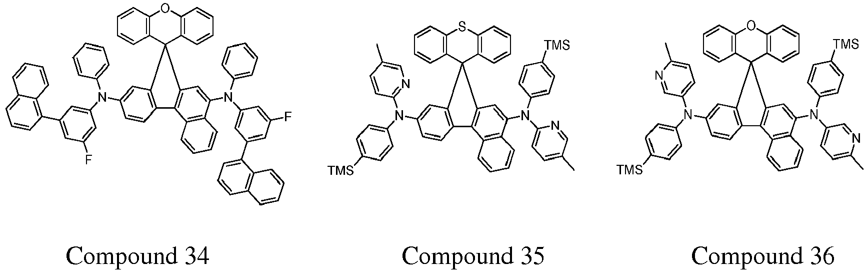

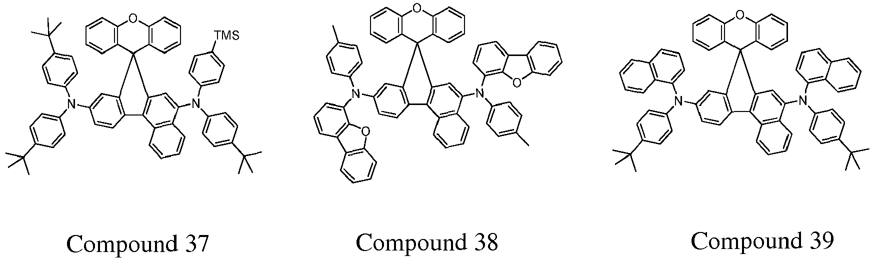

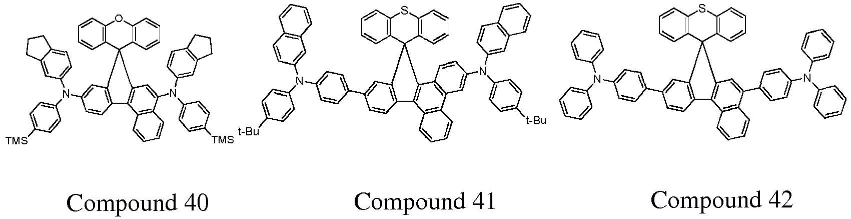

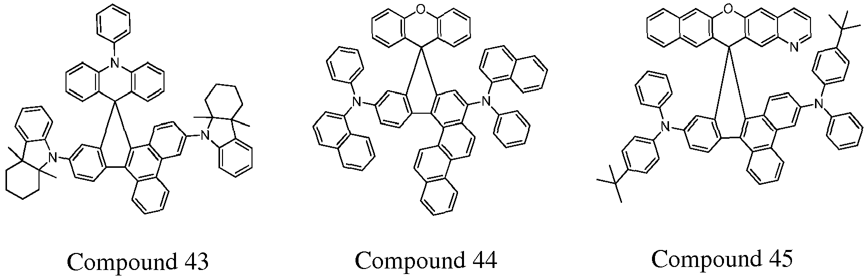

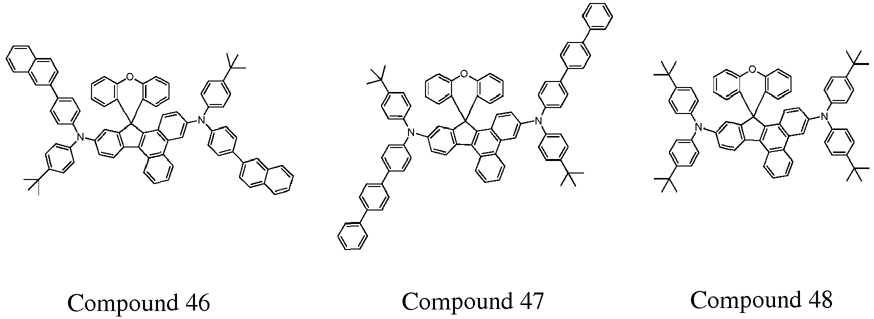

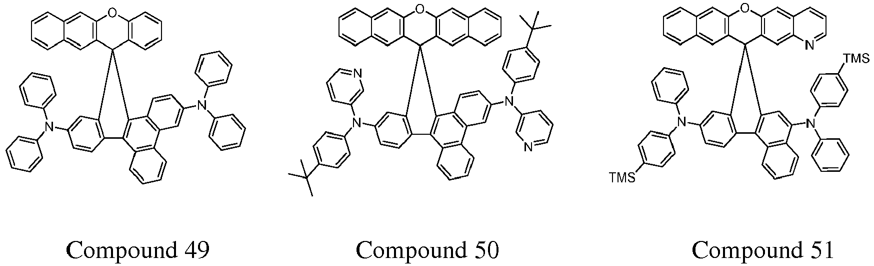

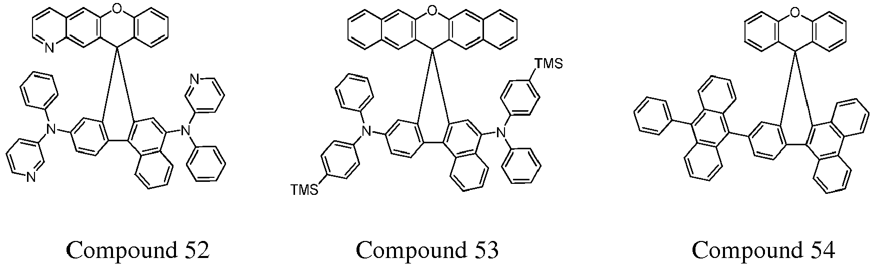

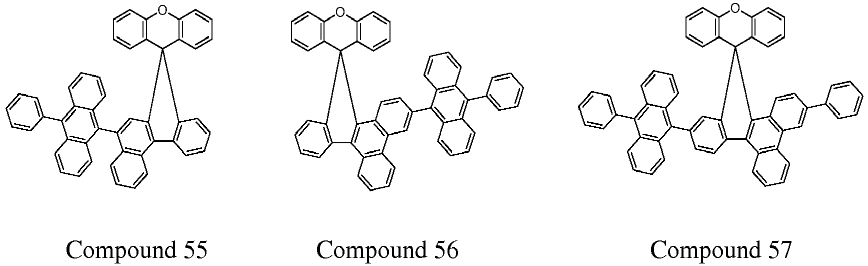

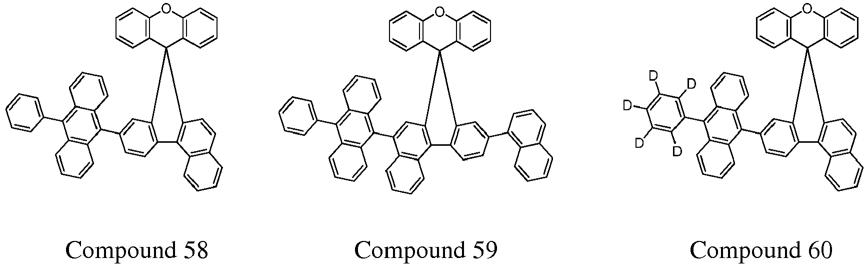

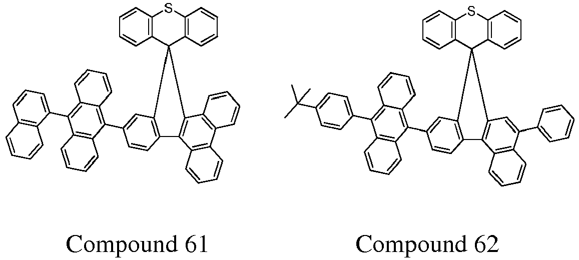

According to preferred embodiments of the present invention, the organic light emitting compounds of Formula II may be selected from the following compounds 101 to 136:

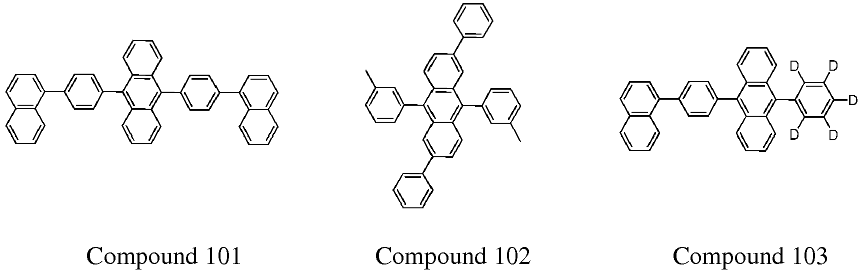

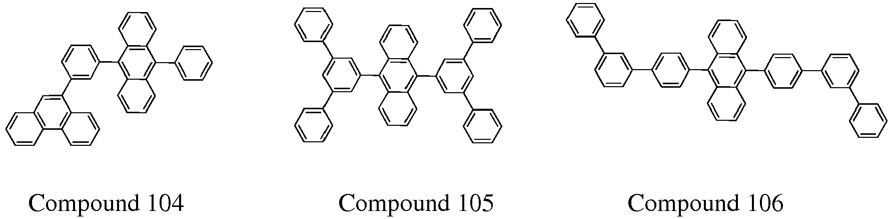

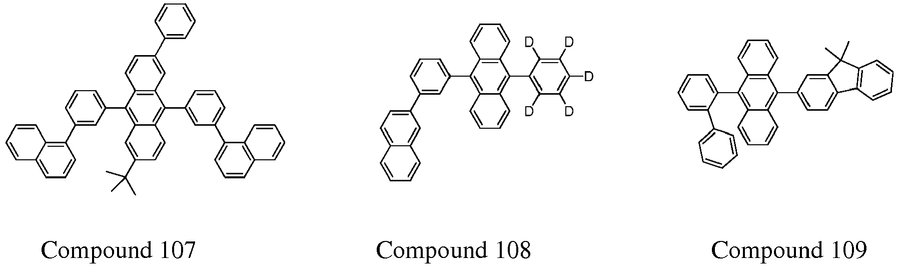

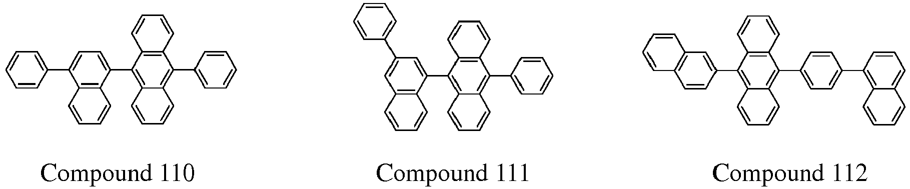

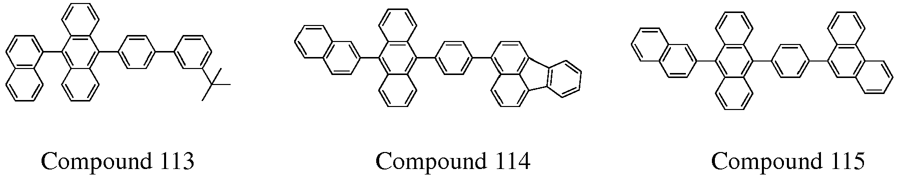

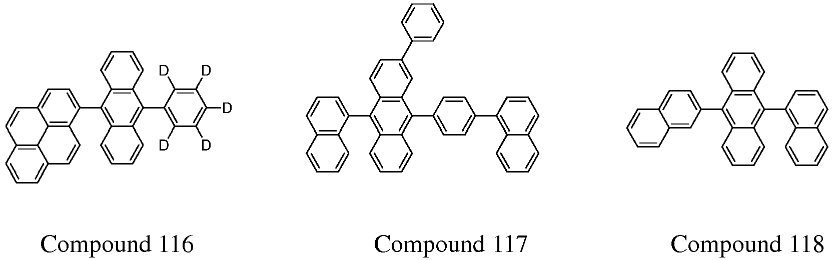

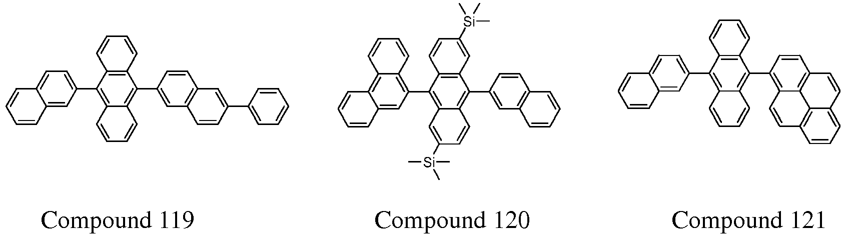

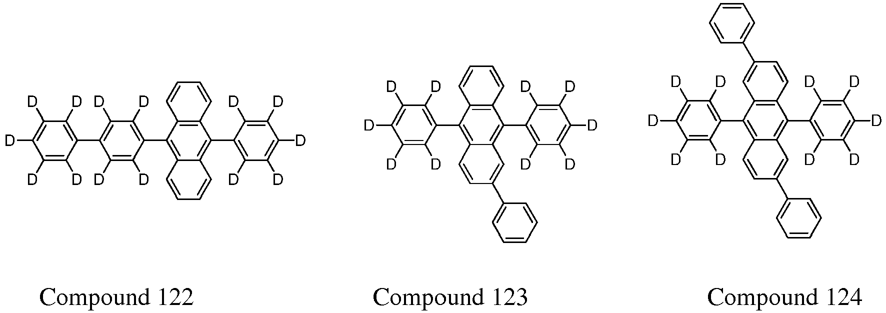

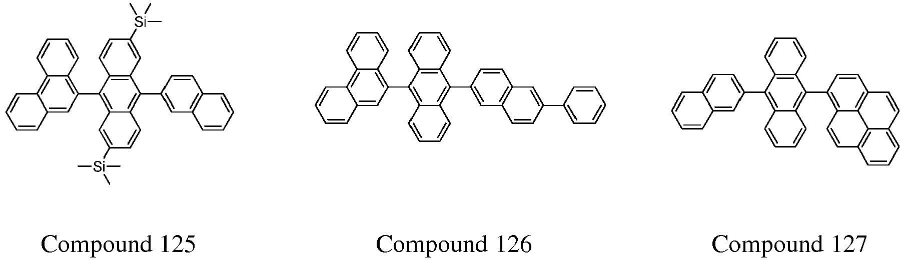

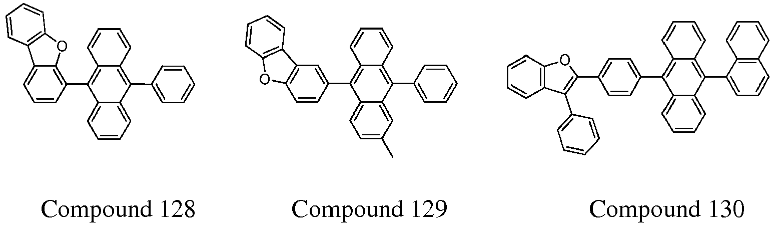

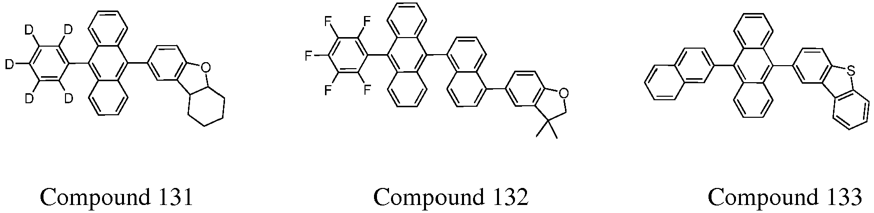

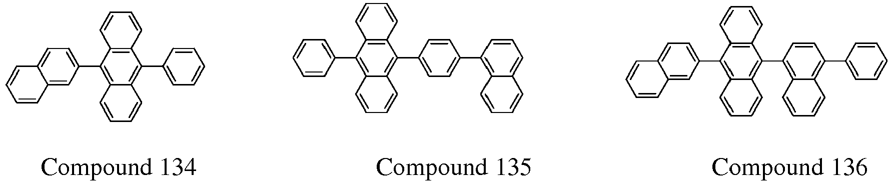

Each of the organic electroluminescence devices according to the present invention includes the organic light emitting compounds 1-5 and 7-62 in a light emitting layer. Each of the organic electroluminescence devices according to the present invention may also include the organic light emitting compounds of Formulae I and II in other organic layers, such as a hole injecting layer, a hole transport layer, a functional layer having functions of both hole injection and hole transport, an electron transport layer, an electron injecting layer, and a layer having functions of both electron injection and electron transport. The presence of the organic light emitting compounds of Formulae I and II can improve the characteristics of the organic electroluminescence devices.

Preferably, each of the organic electroluminescence devices includes the organic light emitting compounds of Formulae I and II in a light emitting layer. First, the light emitting layer may include at least one host compound selected from the compounds of Formula I and at least one dopant compound selected from the compounds of Formula I.

Alternatively, the light emitting layer may include at least one host compound selected from the compounds of Formula I, at least one dopant compound selected from the compounds of Formula I, and at least one host compound selected from the compounds of Formula II.

Alternatively, the light emitting layer may include at least one dopant compound selected from the compounds of Formula I and at least one host compound selected from the compounds of Formula II.

The content of the dopant compound in the light emitting layer of each organic electroluminescence device according to the present invention is typically in the range of about 0.01 to about 20 parts by weight, based on about 100 parts by weight of the host(s).

Hereinafter, the organic electroluminescence devices of the present invention will be explained with reference to FIG. 1.

FIG. 1 is a cross-sectional view schematically illustrating the structure of an organic electroluminescence device according to one embodiment of the present invention. The organic electroluminescence device essentially includes an anode 20, a hole transport layer 40, an organic light emitting layer 50, an electron transport layer 60, and a cathode 80. The organic electroluminescence device may optionally further include a hole injecting layer 30 and an electron injecting layer 70. The organic electroluminescence device is not limited to the structure of FIG. 1. For example, an intermediate layer consisting of one or two layers may be further formed in the organic electroluminescence device. A hole blocking layer or an electron blocking layer may be further formed in the organic electroluminescence device.

Referring to FIG. 1, a detailed description is given of a method for fabricating the organic electroluminescence device of the present invention.

First, an electrode material for the anode 20 is coated on a substrate 10 to form the anode 20. The substrate 10 may be any of those used in general organic electroluminescence (EL) devices. The substrate 10 is preferably an organic substrate or a transparent plastic substrate that is excellent in transparency, surface smoothness, ease of handling, and waterproofness. A highly transparent and conductive metal oxide, such as indium tin oxide (ITO), indium zinc oxide (IZO), tin oxide (SnO₂) or zinc oxide (ZnO), is used as the anode material.

A material for the hole injecting layer 20 is coated on the anode 20 by vacuum thermal evaporation or spin coating to form the hole injecting layer 30. Then, a material for the hole transport layer 40 is coated on the hole injecting layer 30 by vacuum thermal evaporation or spin coating to form the hole transport layer 40.

The material for the hole injecting layer is not specially limited so long as it is usually used in the art. Example of such materials include [4,4',4"-tris(2-naphthyl(phenyl)amino)triphenylamine] (2-TNATA), [N,N'-di(1-naphthyl)-N,N'-diphenylbenzidine)] (NPD), [N,N'-diphenyl-N,N'-bis(3-methylphenyl)-1,1'-biphenyl-4,4'-diamine] (TPD), and [N,N'-diphenyl-N,N'-bis[4-(phenyl-m-tolylamino)phenyl]biphenyl-4,4'-diamine] (DNTPD).

The material for the hole transport layer is not specially limited so long as it is commonly used in the art. Example of such materials include N,N'-bis(3-methylphenyl)-N,N'-diphenyl-[1,1-biphenyl]-4,4'-diamine (TPD) and N,N'-di(naphthalen-1-yl)-N,N'-diphenylbenzidine (α-NPD).

Subsequently, the organic light emitting layer 50 is laminated on the hole transport layer 40. A hole blocking layer (not shown) may be optionally formed on the organic light emitting layer 50 by vacuum thermal evaporation or spin coating. The hole blocking layer blocks holes from entering the cathode through the organic light emitting layer. This role of the hole blocking layer prevents the life and efficiency of the device from deteriorating. A material having a very low highest occupied molecular orbital (HOMO) energy level is used for the hole blocking layer. The hole blocking material is not particularly limited so long as it has the ability to transport electrons and a higher ionization potential than the light emitting compound. Representative examples of suitable hole blocking materials include BAlq, BCP, and TPBI.

The electron transport layer 60 is deposited on the hole blocking layer by vacuum thermal evaporation or spin coating, and the electron injecting layer 70 is formed thereon. A metal for the cathode is deposited on the electron injecting layer 70 by vacuum thermal evaporation to form the cathode 80, completing the fabrication of the organic EL device. As the metal for the cathode, there may be used, for example, lithium (Li), magnesium (Mg), aluminum (Al), aluminum-lithium (Al-Li), calcium (Ca), magnesium-indium (Mg-In) or magnesium-silver (Mg-Ag). The organic EL device may be of top emission type. In this case, a transmissive material, such as ITO or IZO, may be used for the cathode.

The material for the electron transport layer functions to stably transport electrons injected from the electron injecting electrode (i.e. the cathode). The material for the electron transport layer may be any known electron transport material, and examples thereof include, but are not limited to, quinoline derivatives, particularly, tris(8-quinolinolate)aluminum (Alq3), TAZ, Balq, beryllium bis(benzoquinolin-10-olate (Bebq2), and AND, and oxadiazole derivatives, such as PBD, BMD, and BND.

One or more layers selected from the hole injecting layer, the hole transport layer, the electron blocking layer, the light emitting layer, the hole blocking layer, the electron transport layer, and the electron injecting layer may be formed by a monomolecular deposition or solution process. According to the monomolecular deposition process, the material for each layer is evaporated under heat and vacuum or reduced pressure to form the layer in the form of a thin film. According to the solution process, the material for each layer is mixed with a suitable solvent, and then the mixture is formed into a thin film by a suitable method, such as ink-jet printing, roll-to-roll coating, screen printing, spray coating, dip coating or spin coating.

The organic electroluminescence devices of the present invention can be used in a variety of systems, such as flat panel displays, flexible displays, monochromatic flat panel lighting systems, white flat panel lighting systems, flexible monochromatic lighting systems, and flexible white lighting systems.

The present invention will be explained in more detail with reference to the following examples. However, it will be obvious to those skilled in the art that these examples are provided for illustrative purposes and are not intended to limit the scope of the invention.

### Synthesis Example 1: Synthesis of Compound 1

### [Reaction 1-1] Synthesis of Intermediate 1-a

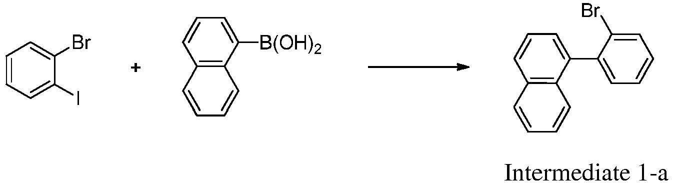

1-Naphthaleneboronic acid (12.5 g, 0.073 mol), 1-bromo-2-iodobenzene (17.3 g, 0.061 mol), tetrakis(triphenylphosphine)palladium (3.62 g, 0.003 mol), and potassium carbonate (16.9 g, 0.122 mol) were added to a mixed solvent of 150 mL of 1,4-dioxane, 150 mL of toluene, and 60 mL of distilled water. The mixture was refluxed for 12 h. The reaction mixture was allowed to cool to room temperature and extracted with ethyl acetate. Purification by column chromatography afforded 14.7 g (yield 85%) of Intermediate 1-a.

### [Reaction 1-2] Synthesis of Intermediate 1-b

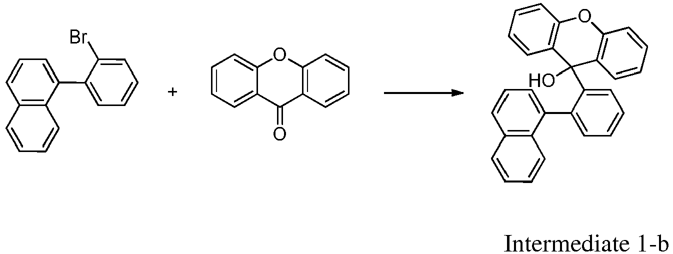

Intermediate 1-a (3.5 g, 12.2 mmol) was added to 50 mL of tetrahydrofuran, and n-butyllithium (5.8 mL, 14.6 mmol) was added dropwise thereto at -78 °C. The mixture was stirred for about 1 h. To the mixture was slowly added dropwise a solution of 9-xanthone (2.1 g, 10.8 mmol) in 10 mL of tetrahydrofuran at the same temperature. The resulting mixture was stirred for 2 h. Stirring was continued at room temperature for 12 h. The reaction mixture was extracted with ethyl acetate and recrystallized from diethyl ether, affording 3.2 g (yield 75%) of Intermediate 1-b.

### [Reaction 1-3] Synthesis of Intermediate 1-c

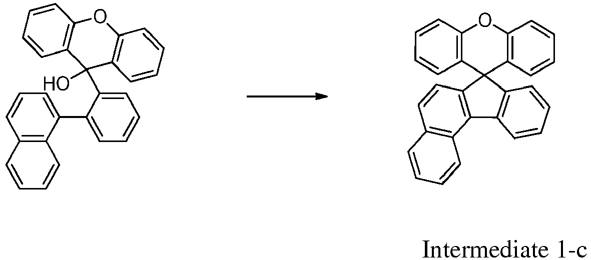

Intermediate 1-b (26.5 g, 66.3 mmol) was added to 300 mL of acetic acid. The mixture was heated to 80 °C, and then 1-2 drops of an aqueous solution of hydrochloric acid was added thereto. The resulting mixture was refluxed for about 2 h. After cooling to room temperature, filtration of the reaction mixture afforded 22.8 g (yield 90%) of Intermediate 1-c.

### [Reaction 1-4] Synthesis of Intermediate 1-d

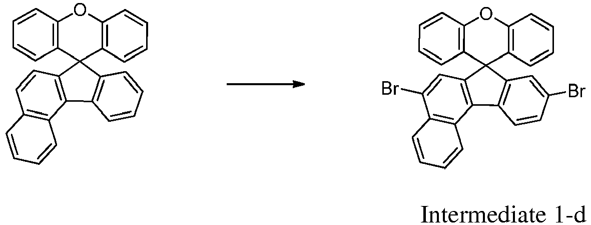

Intermediate 1-c (21 g, 0.055 mol) was added to 250 mL of dimethylformamide. The mixture was stirred at 0 °C. To the mixture was added dropwise a solution of N-bromosuccinimide (21.5 g, 0.121 mol) in 70 mL of dimethylformamide. The resulting mixture was stirred for 6 h. The reaction mixture was diluted with distilled water and washed with hexane. The crude product was dissolved in dichloromethane, heated, treated with acid clay and activated carbon, washed with dichloromethane, and recrystallized from hexane, affording 17.8 g (yield 60%) of Intermediate 1-d.

### [Reaction 1-5] Synthesis of Compound 1

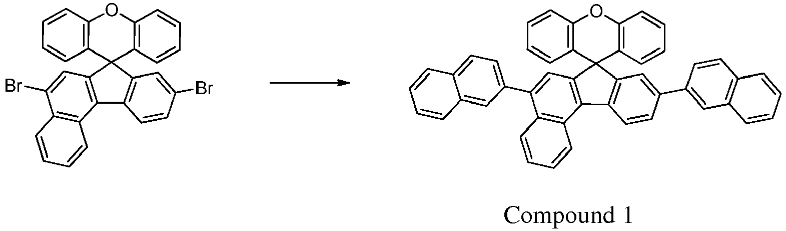

The procedure of Reaction 1-1 was repeated except that 2-naphthaleneboronic acid was used instead of 1-naphthaleneboronic acid and Intermediate 1-d synthesized in Reaction 1-4 was used instead of 1-bromo-2-iodobenzene. As a result, Compound 1 was prepared in a yield of 64%.

### Synthesis Example 2: Synthesis of Compound 7

Compound 7 (yield 66%) was prepared in the same manner as in Synthesis Example 1, except that 9-phenanthreneboronic acid and 2-bromo-1-iodonaphthalene were used instead of 1-naphthaleneboronic acid and 1-bromo-2-iodobenzene in Reaction 1-1, respectively, and 1-naphthaleneboronic acid was used instead of 2-naphthaleneboronic acid in Reaction 1-5.

### Synthesis Example 3: Synthesis of Compound 14

### [Reaction 3-1] Synthesis of Intermediate 3-a

Intermediate 3-a (yield 88%) was prepared in the same manner as in Reactions 1-1 to 1-3, except that quinoline-5-boronic acid was used instead of 1-naphthaleneboronic acid and 2,4-dibromo-1-iodobenzene was used instead of 1-bromo-2-iodobenzene in Reaction 1-1.

### [Reaction 3-2] Synthesis of Compound 14

The procedure of Reaction 1-1 was repeated except that 2-naphthaleneboronic acid was used instead of 1-naphthaleneboronic acid and Intermediate 3-a synthesized in Reaction 3-1 was used instead of 1-bromo-2-iodobenzene. As a result, Compound 14 was prepared in a yield of 70%.

### Synthesis Example 4: Synthesis of Compound 19

Compound 19 (yield 62%) was prepared in the same manner as in Synthesis Example 1, except that 9-phenanthreneboronic acid was used instead of 1-naphthaleneboronic acid in Reaction 1-1, 10-thioxanthone was used instead of 9-xanthone in Reaction 1-2, and 1-naphthaleneboronic acid was used instead of 2-naphthaleneboronic acid in Reaction 1-5.

### Synthesis Example 5: Synthesis of Compound 22

### [Reaction 5-1] Synthesis of Intermediate 5-a

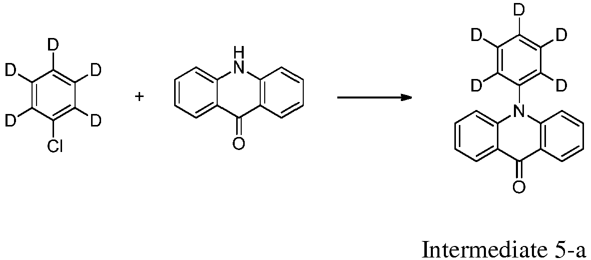

Pentadeuterochlorobenzene (11.7 g, 0.1 mol), 9-acridone (19.5 g, 0.1 mol), palladium acetate (0.08 g, 0.32 mmol), 2,2'-bis(diphenylphosphino)-1-1'-binaphthyl (0.26 g, 0.42 mmol), and sodium tert-butoxide (15.2 g, 0.16 mol) were added to 200 mL of toluene. The mixture was refluxed for 12 h. The reaction mixture was allowed to cool to room temperature, washed with methanol, and recrystallized from dichloromethane and methanol, affording 20.7 g (yield 75%) of Intermediate 5-a.

### [Reaction 5-2] Synthesis of Compound 22

Compound 22 (yield 62%) was prepared in the same manner as in Synthesis Example 1, except that Intermediate 5-a synthesized in Reaction 5-1 was used instead of 9-xanthone in Reaction 1-2.

### Synthesis Example 6: Synthesis of Compound 26

The procedure of Reaction 5-1 was repeated except that Intermediate 1-d synthesized in Reaction 1-4 was used instead of pentadeuterochlorobenzene and diphenylamine was used instead of 9-acridone. As a result, Compound 26 was prepared in a yield of 65%.

### Synthesis Example 7: Synthesis of Compound 30

### [Reaction 7-1] Synthesis of Intermediate 7-a

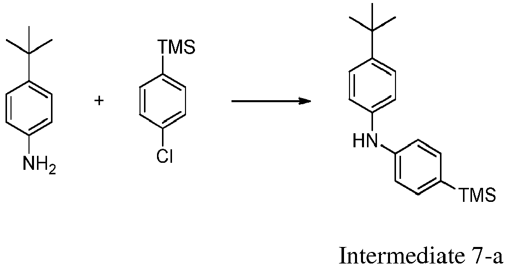

The procedure of Reaction 5-1 was repeated except that (4-chlorophenyl)trimethylsilane was used instead of pentadeuterochlorobenzene and 4-amino-tert-butylbenzene was used instead of 9-acridone. As a result, Intermediate 7-a was prepared in a yield of 75%.

### [Reaction 7-2] Synthesis of Compound 30

The procedure of Reaction 5-1 was repeated except that Intermediate 1-d synthesized in Reaction 1-4 was used instead of pentadeuterochlorobenzene and Intermediate 7-a synthesized in Reaction 7-1 was used instead of 9-acridone. As a result, Compound 30 was prepared in a yield of 62%.

### Synthesis Example 8: Synthesis of Compound 35

### [Reaction 8-1] Synthesis of Intermediate 8-a

Intermediate 8-a (yield 58%) was prepared in the same manner as in Reactions 1-1 to 1-4, except that 10-thioxanthone was used instead of 9-xanthone in Reaction 1-2.

### [Reaction 8-2] Synthesis of Intermediate 8-b

The procedure of Reaction 5-1 was repeated except that (4-chlorophenyl)trimethylsilane was used instead of pentadeuterochlorobenzene and 2-amino-5-methylpyridine was used instead of 9-acridone. As a result, Intermediate 8-b was prepared in a yield of 73%.

### [Reaction 8-3] Synthesis of Compound 35

The procedure of Reaction 5-1 was repeated except that Intermediate 8-a synthesized in Reaction 8-1 was used instead of pentadeuterochlorobenzene and Intermediate 8-b synthesized in Reaction 8-2 was used instead of 9-acridone. As a result, Compound 35 was prepared in a yield of 64%.

### Synthesis Example 9: Synthesis of Compound 38

### [Reaction 9-1] Synthesis of Intermediate 9-a

The procedure of Reaction 5-1 was repeated except that 4-bromodibenzofuran was used instead of pentadeuterochlorobenzene and 1-amino-4-methylbenzene was used instead of 9-acridone. As a result, Intermediate 9-a was prepared in a yield of 72%.

### [Reaction 9-2] Synthesis of Compound 38

The procedure of Reaction 5-1 was repeated except that Intermediate 1-d synthesized in Reaction 1-4 was used instead of pentadeuterochlorobenzene and Intermediate 9-a synthesized in Reaction 9-1 was used instead of 9-acridone. As a result, Compound 38 was prepared in a yield of 60%.

### Synthesis Example 10: Synthesis of Compound 42

### [Reaction 10-1] Synthesis of Intermediate 10-a

The procedure of Reaction 5-1 was repeated except that 4-chlorophenylboronic acid was used instead of pentadeuterochlorobenzene and diphenylamine was used instead of 9-acridone. As a result, Intermediate 10-a was prepared in a yield of 75%.

### [Reaction 10-2] Synthesis of Compound 42

The procedure of Reaction 1-1 was repeated except that Intermediate 10-a synthesized in Reaction 10-1 was used instead of 1-naphthaleneboronic acid and Intermediate 8-a synthesized in Reaction 8-1 was used instead of 1-bromo-2-iodobenzene. As a result, Compound 42 was prepared in a yield of 65%.

### Synthesis Example 11: Synthesis of Compound 43

### [Reaction 11-1] Synthesis of Intermediate 11-a

The procedure of Reaction 5-1 was repeated except that chlorobenzene was used instead of pentadeuterochlorobenzene. As a result, Intermediate 11-a was prepared in a yield of 77%.

### [Reaction 11-2] Synthesis of Intermediate 11-b

Intermediate 11-b (yield 58%) was prepared in the same manner as in Reactions 1-1 to 1-4, except that 9-phenanthreneboronic acid was used instead of 1-naphthaleneboronic acid in Reaction 1-1 and Intermediate 11-a synthesized in Reaction 11-1 was used instead of 9-xanthone in Reaction 1-2.

### [Reaction 11-3] Synthesis of Intermediate 11-c

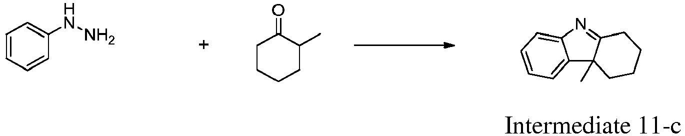

Phenylhydrazine (44.3 g, 0.41 mol) was added to 170 mL of acetic acid. The mixture was heated to 60 °C. To the mixture was slowly added dropwise 2-methylcyclohexanone (45.9 g, 0.41 mol). The resulting mixture was refluxed for 8 h. After completion of the reaction, to the reaction mixture was added 100 mL of distilled water. The mixture was basified with sodium hydroxide and extracted with ethyl acetate. Purification by column chromatography afforded 63.8 g (yield 84%) of Intermediate 11-c.

### [Reaction 11-4] Synthesis of Intermediate 11-d

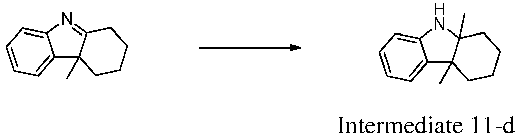

Intermediate 11-c (37 g, 0.2 mol) was dissolved in 400 mL of toluene. The solution was cooled to -10 °C, and 188 mL of 1.6 M methyllithium was added dropwise thereto. After 3 h stirring, the reaction mixture was extracted with ethyl acetate. Purification by column chromatography afforded 30.6 g (yield 76%) of Intermediate 11-d.

### [Reaction 11-5] Synthesis of Compound 43

The procedure of Reaction 5-1 was repeated except that Intermediate 11-b synthesized in Reaction 11-2 was used instead of pentadeuterochlorobenzene and Intermediate 11-d synthesized in Reaction 11-4 was used instead of 9-acridone. As a result, Compound 43 was prepared in a yield of 62%.

### Synthesis Example 12: Synthesis of Compound 46

### [Reaction 12-1] Synthesis of Intermediate 12-a

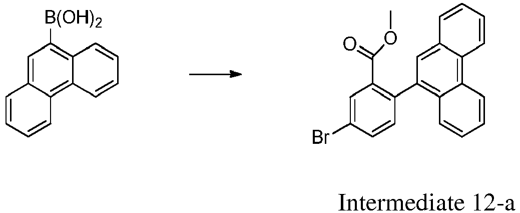

Methyl 5-bromo-2-iodobenzoate (64.5 g, 189 mmol), 9-phenanthreneboronic acid (35.0 g, 158 mmol), tetrakis(triphenylphosphine)palladium (3.65 g, 3 mmol), potassium carbonate (43.6 g, 315 mmol), tetrahydrofuran (322 ml), toluene (322 ml), and water (129 ml) were mixed together and refluxed. The reaction mixture was extracted with ethyl acetate. The obtained organic layer was dried over magnesium sulfate and concentrated under reduced pressure. The concentrate was purified by column chromatography, affording 37.6 g (yield 61%) of Intermediate 12-a.

### [Reaction 12-2] Synthesis of Intermediate 12-b

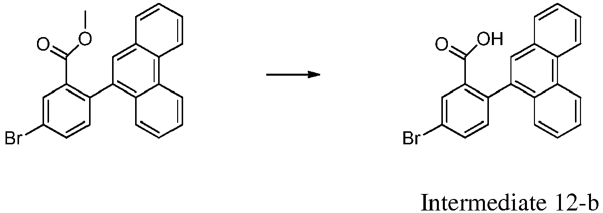

Intermediate 12-a (37.0 g, 95 mmol) and sodium hydroxide (4.54 g, 113 mmol) were allowed to react under reflux in ethanol (370 ml). After completion of the reaction, the reaction mixture was cooled to room temperature, acidified with 2 N hydrochloric acid, and filtered. The filtered crystal was washed three times with water and dried, affording 27.5 g (yield 77%) of Intermediate 12-b.

### [Reaction 12-3] Synthesis of Intermediate 12-c

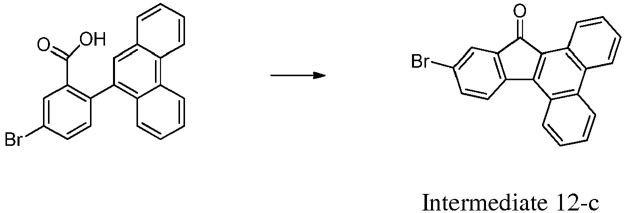

Intermediate 12-b (27.0 g, 72 mmol) and methanesulfonic acid (270 mL) were allowed to react with stirring at a temperature of 40 °C for 72 h. After completion of the reaction, the reaction mixture was slowly added to ice-water, and dichloromethane and water were added thereto for layer separation. The organic layer was concentrated under reduced pressure. The concentrate was purified by column chromatography, affording 20.3 g (yield 79%) of Intermediate 12-c.

### [Reaction 12-4] Synthesis of Intermediate 12-d

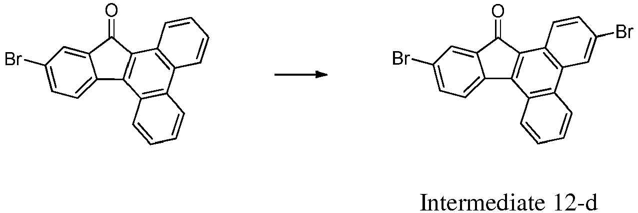

Intermediate 12-c (20.0 g, 56 mmol) and chloroform (200 mL) were mixed with stirring. To the mixture was slowly added dropwise a dilute solution of bromine (26.7 g, 167 mmol) in chloroform (40 mL). After completion of the reaction, to the reaction mixture was added dropwise a saturated solution of sodium thiosulfate. The crystal was collected by filtration, washed several times with water, dried, and recrystallized from monochlorobenzene and heptane, affording 20.5 g (yield 84%) of Intermediate 12-d.

### [Reaction 12-5] Synthesis of Intermediate 12-e

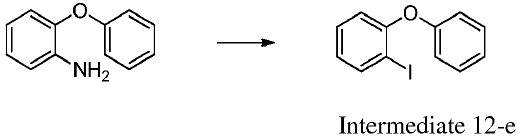

2-Phenyloxyaniline (25.0 g, 135 mmol), 36% hydrochloric acid (50.0 mL), and water (50 mL) was cooled to 0 °C, and a solution of sodium nitrite (14.0 g, 202 mmol) in water (42 mL) was added dropwise thereto. The mixture was stirred for 1 h. To the mixture was added dropwise a solution of potassium iodide (44.8 g, 270 mmol) in water (90 mL). The resulting mixture was stirred for 1 h at room temperature. After heating to 60 °C, stirring was continued for 12 h. The reaction mixture was allowed to cool to room temperature and sequentially extracted with dichloromethane, a saturated solution of sodium thiosulfate, and water. The extract was concentrated under reduced pressure and purified by column chromatography, affording 22.4 g (yield 56%) of Intermediate 12-e.

### [Reaction 12-6] Synthesis of Intermediate 12-f

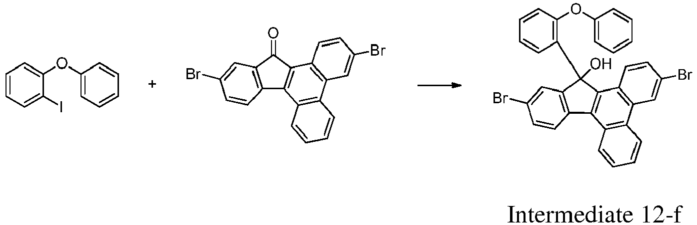

A mixture of Intermediate 12-e (20.3 g, 68 mmol) and tetrahydrofuran (200 mL) was cooled to -78 °C, and n-butyllithium (39.9 ml, 64 mmol, 1.6 M) was slowly added dropwise thereto. The mixture was stirred for 2 h. To the mixture was added Intermediate 12-d (20.0 g, 46 mmol). Stirring was continued at room temperature for 12 h. The reaction was quenched with water (100 mL). The reaction mixture was extracted with dichloromethane and concentrated under reduced pressure, affording 21.7 g (yield 78%) of Intermediate 12-f.

### [Reaction 12-7] Synthesis of Intermediate 12-g

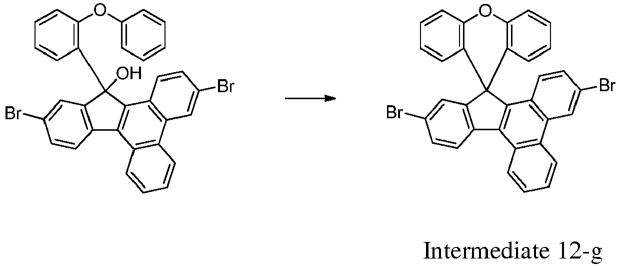

Intermediate 12-f (21 g, 35 mmol), acetic acid(210 mL), and sulfuric acid (2 mL) were mixed together and refluxed. After completion of the reaction, the reaction was cooled to room temperature. The reaction mixture was filtered to obtain a solid. The solid was washed three times with water and methanol and recrystallized from toluene and methanol, affording 17.7 g (yield 87%) of Intermediate 12-g.

### [Reaction 12-8] Synthesis of Intermediate 12-h

The procedure of Reaction 1-1 was repeated except that 2-naphthaleneboronic acid was used instead of 1-naphthaleneboronic acid and 4-bromoaniline was used instead of 1-bromo-2-iodobenzene. As a result, Intermediate 12-h was prepared in a yield of 46%.

### [Reaction 12-9] Synthesis of Intermediate 12-i

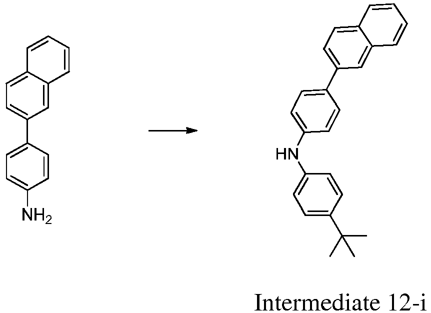

Intermediate 12-h (10.0 g, 46 mmol), 1-bromo-4-tert-butylbenzene (9.2 g, 43 mmol), tris(dibenzylideneacetone)dipalladium (0) (0.8 g, 1 mmol), 2,2'-bis(diphenylphosphino)-1,1'-binaphthyl (0.6 g, 1 mmol), and sodium tert-butoxide (8.8 g, 91 mmol) were mixed together and refluxed. After cooling to room temperature, the reaction mixture was extracted with ethyl acetate, dried over sodium sulfate, and concentrated under reduced pressure. The concentrate was purified by column chromatography, affording 10.7 g (yield 70%) of Intermediate 12-i.

### [Reaction 12-10] Synthesis of Compound 46

The procedure of Reaction 5-1 was repeated except that Intermediate 12-g synthesized in Reaction 12-7 was used instead of pentadeuterochlorobenzene and Intermediate 12-i synthesized in Reaction 12-9 was used instead of 9-acridone. As a result, Compound 46 was prepared in a yield of 40%.

### Synthesis Example 13: Synthesis of Compound 47

### [Reaction 13-1] Synthesis of Intermediate 13-a

The procedure of Reaction 1-1 was repeated except that 4-biphenylboronic acid was used instead of 1-naphthaleneboronic acid and 1-bromo-4-iodobenzene was used instead of 1-bromo-2-iodobenzene. As a result, Intermediate 13-a was prepared in a yield of 65%.

### [Reaction 13-2] Synthesis of Intermediate 13-b

The procedure of Reaction 12-9 was repeated except that 4-tert-butylaniline was used instead of Intermediate 12-h and Intermediate 13-a synthesized in Reaction 13-1 was used instead of 1-bromo-4-tert-butylbenzene. As a result, Intermediate 13-b was prepared in a yield of 64%.

### [Reaction 13-3] Synthesis of Compound 47

The procedure of Reaction 5-1 was repeated except that Intermediate 12-g synthesized in Reaction 12-7 was used instead of pentadeuterochlorobenzene and Intermediate 13-b synthesized in Reaction 13-2 was used instead of 9-acridone. As a result, Compound 47 was prepared in a yield of 41%.

### Synthesis Example 14: Synthesis of Compound 48

### [Reaction 14-1] Synthesis of Intermediate 14-a

The procedure of Reaction 12-9 was repeated except that 4-tert-butylaniline was used instead of Intermediate 12-h. As a result, Intermediate 14-a was prepared in a yield of 60%.

### [Reaction 14-2] Synthesis of Compound 48

The procedure of Reaction 5-1 was repeated except that Intermediate 12-g synthesized in Reaction 12-7 was used instead of pentadeuterochlorobenzene and Intermediate 14-a synthesized in Reaction 14-1 was used instead of 9-acridone. As a result, Compound 48 was prepared in a yield of 40%.

### Synthesis Example 15: Synthesis of Compound 55

### [Reaction 15-1] Synthesis of Intermediate 15-a

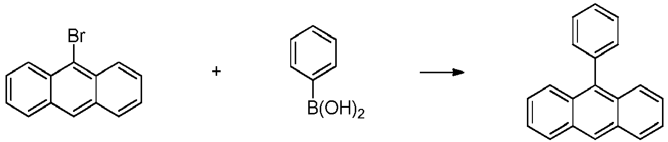

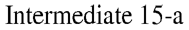

9-Bromoanthracene (15.0 g, 58 mmol), tetrakis(triphenylphosphine)palladium (2.02 g, 0.18 mmol), phenylboronic acid (8.5 g, 70 mol), and potassium carbonate (16.13 g, 116.7 mmol) were added to a reactor, and 75 mL of toluene, 75 mL of tetrahydrofuran, and 30 mL of water were added thereto. The temperature of the reactor was raised to 90 °C. The mixture was stirred overnight. After completion of the reaction, the temperature of the reactor was reduced to room temperature. The reaction mixture was extracted with ethyl acetate. The extract was purified by column chromatography, affording 11.0 g (yield 74%) of Intermediate 15-a.

### [Reaction 15-2] Synthesis of Intermediate 15-b

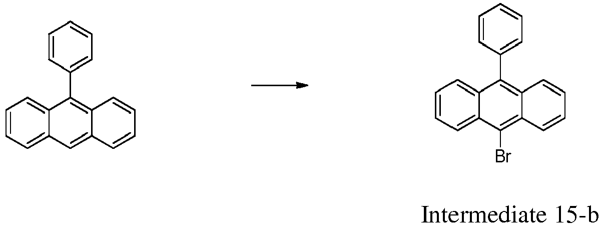

Intermediate 15-a (11.0 g, 43 mmol) was dissolved in 110 mL of N,N-dimethylformamide. To the solution was slowly added N-bromosuccinimide (8.5 g, 48 mmol). The mixture was stirred at room temperature. To the reaction solution was slowly added 100 mL of distilled water. The resulting mixture was stirred for about 1 h. The obtained solid was collected by filtration. The solid was sufficiently washed with distilled water and recrystallized from n-hexane, affording 12.0 g (yield 83%) of Intermediate 15-b.

### [Reaction 15-3] Synthesis of Intermediate 15-c

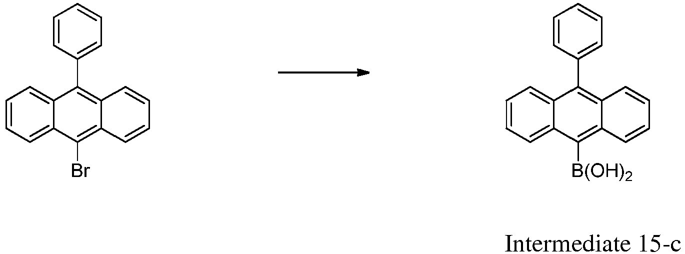

Intermediate 15-b (12.0 g, 36 mmol) was dissolved in 100 mL of tetrahydrofuran. After cooling to -78 °C under a nitrogen atmosphere, n-butyllithium (24.76 mL, 40 mmol) was slowly added dropwise for 30 min. The mixture was stirred at the same temperature for 1 h. To the mixture was added dropwise trimethyl borate (4.5 g, 43 mmol) at the same temperature. The resulting mixture was stirred at room temperature overnight. The reaction solution was acidified by dropwise addition of 2 N hydrochloric acid. After 1 h stirring, the mixture was extracted with ethyl acetate and recrystallized from hexane, affording 7.5 g (yield 69%) of Intermediate 15-c.

### [Reaction 15-4] Synthesis of Intermediate 15-d

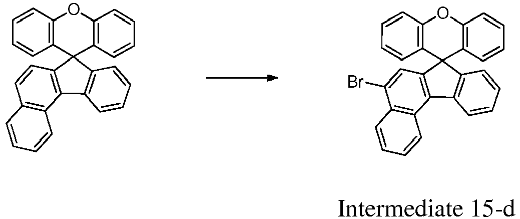

The procedure of Reaction 15-2 was repeated except that Intermediate 1-c was used instead of Intermediate 15-a. As a result, Intermediate 15-d was prepared in a yield of 50%.

### [Reaction 15-5] Synthesis of Compound 55

The procedure of Reaction 1-1 was repeated except that Intermediate 15-c synthesized in Reaction 15-3 was used instead of 1-naphthaleneboronic acid and Intermediate 15-d synthesized in Reaction 15-4 was used instead of 1-bromo-2-iodobenzene. As a result, Compound 55 was prepared in a yield of 52%.

### Synthesis Example 16: Synthesis of Compound 56

### [Reaction 16-1] Synthesis of Intermediate 16-a

Intermediate 16-a (yield 89%) was prepared in the same manner as in Reactions 1-1 to 1-3, except that 9-phenanthreneboronic acid was used instead of 1-naphthaleneboronic acid in Reaction 1-1.

### [Reaction 16-2] Synthesis of Compound 56

Compound 56 (yield 50%) was prepared in the same manner as in Synthesis Example 15, except that Intermediate 16-a synthesized in Reaction 16-1 was used instead of Intermediate 1-c in Reaction 15-4.

### Examples 1-14: Fabrication of organic light emitting diodes

ITO glass was patterned to have a light emitting area of 2 mm × 2 mm, followed by cleaning. After the cleaned ITO glass was mounted in a vacuum chamber, the base pressure was adjusted to 1 × 10⁻⁶ torr. DNTPD (700 Å), α-NPD (300 Å), Compound 134 as a host for a light emitting layer, and the corresponding dopant compound (3 wt%) shown in Table 1 were sequentially co-deposited on the ITO. Thereafter, an Alq₃ layer (350 Å), a LiF layer (5 Å), and an Al layer (1,000 Å) were formed in this order on the light emitting layer to fabricate an organic light emitting diode. The luminescent properties of the organic light emitting diode were measured at 0.4 mA.

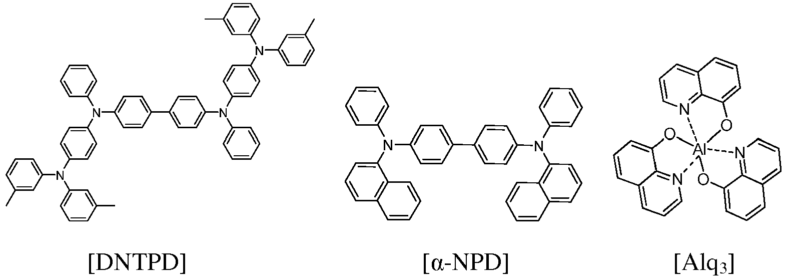

### Examples 15-18

Organic light emitting diodes were fabricated in the same manner as in Examples 1-14, except that Compound 112 and Compound 110 were used as hosts for light emitting layers instead of Compound 134 and the compounds shown in Table 1 were used as dopants.

### Comparative Examples 1-2

Organic light emitting devices were fabricated in the same manner as in Examples 1-18, except that the compounds represented by BD1 and BD2 were used as dopant compounds. The structures of BD1 and BD2 are as follows:

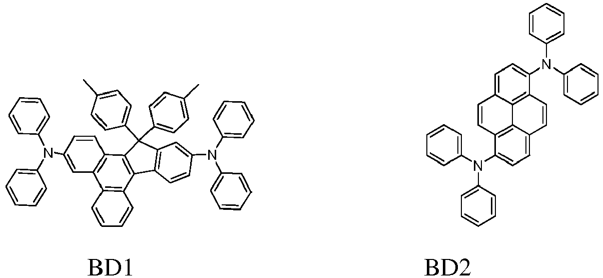

The organic light emitting devices fabricated in Examples 1-18 and Comparative Examples 1-2 were measured for voltage, luminance, quantum efficiency, and color coordinates. The results are shown in Table 1.

**TABLE 1**

| Example No. | Host | Dopant | Voltage (V) | Luminance (Cd/m²) | Quantum efficiency | CIE x | CIE y |
|---|---|---|---|---|---|---|---|
| Example 1 | Compound 134 | Compound 1 | 3.8 | 770 | 8.2 | 0.14 | 0.11 |
| Example 2 | Compound 134 | Compound 7 | 3.9 | 771 | 8.0 | 0.14 | 0.11 |
| Example 3 | Compound 134 | Compound 14 | 3.8 | 785 | 7.9 | 0.14 | 0.12 |
| Example 4 | Compound 134 | Compound 19 | 3.8 | 784 | 8.1 | 0.14 | 0.11 |
| Example 5 | Compound 134 | Compound 22 | 3.8 | 780 | 8.1 | 0.14 | 0.11 |
| Example 6 | Compound 134 | Compound 26 | 3.8 | 769 | 8.0 | 0.14 | 0.12 |
| Example 7 | Compound 134 | Compound 30 | 3.8 | 762 | 8.2 | 0.14 | 0.11 |
| Example 8 | Compound 134 | Compound 35 | 3.8 | 772 | 8.3 | 0.14 | 0.11 |
| Example 9 | Compound 134 | Compound 38 | 3.8 | 798 | 7.9 | 0.14 | 0.11 |
| Example 10 | Compound 134 | Compound 42 | 3.8 | 769 | 7.9 | 0.14 | 0.11 |
| Example 11 | Compound 134 | Compound 44 | 3.9 | 777 | 8.1 | 0.14 | 0.11 |
| Example 12 | Compound 134 | Compound 46 | 3.8 | 811 | 9.0 | 0.14 | 0.12 |
| Example 13 | Compound 134 | Compound 47 | 3.8 | 825 | 9.2 | 0.14 | 0.11 |
| Example 14 | Compound 134 | Compound 48 | 3.7 | 819 | 9.5 | 0.13 | 0.12 |
| Example 15 | Compound 112 | Compound 46 | 3.8 | 831 | 9.6 | 0.13 | 0.12 |
| Example 16 | Compound 110 | Compound 46 | 3.7 | 830 | 9.8 | 0.14 | 0.11 |
| Example 17 | Compound 112 | Compound 47 | 3.7 | 842 | 9.5 | 0.14 | 0.12 |
| Example 18 | Compound 110 | Compound 47 | 3.9 | 843 | 9.4 | 0.14 | 0.10 |
| Comparative Example 1 | Compound 134 | BD 1 | 3.7 | 750 | 6.0 | 0.14 | 0.13 |
| Comparative Example 2 | Compound 134 | BD 2 | 4.3 | 515 | 5.1 | 0.15 | 0.17 |

### Examples 19-20: Fabrication of organic light emitting diodes

ITO glass was patterned to have a light emitting area of 2 mm × 2 mm, followed by cleaning. After the cleaned ITO glass was mounted in a vacuum chamber, the base pressure was adjusted to 1 × 10⁻⁶ torr. A DNTPD layer (700 Å) and an α-NPD layer (300 Å) were sequentially formed on the ITO glass, and a mixture of the corresponding host compound shown in Table 2 and BD3 (3%) was deposited to a thickness of 250 Å thereon to form a light emitting layer. Thereafter, an Alq₃ (350 Å) layer, a LiF layer (5 Å), and an Al layer (1,000 Å) were formed in this order on the light emitting layer to fabricate an organic light emitting diode. The luminescent properties of the organic light emitting diode were measured at 0.4 mA. The structure of BD3 is as follows:

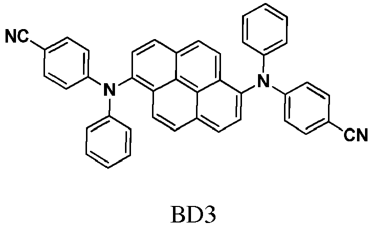

### Comparative Examples 3-4

Organic light emitting devices were fabricated in the same manner as in Examples 19-20, except that Compound 135 was used as a host compound.

The organic light emitting devices fabricated in Examples 19-20 and Comparative Examples 3-4 were measured for voltage, luminance, quantum efficiency, and color coordinates. The results are shown in Table 2.

**TABLE 2**

| Example No. | Host | Dopant | Voltage (V) | Luminance (Cd/m²) | Quantum efficiency | CIE x | CIE y |
|---|---|---|---|---|---|---|---|
| Example 19 | Compound 55 | BD 3 | 3.8 | 759 | 8.2 | 0.14 | 0.12 |
| Example 20 | Compound 56 | BD 3 | 3.8 | 765 | 8.0 | 0.14 | 0.11 |
| Comparative Example 3 | Compound 135 | BD 3 | 4.3 | 550 | 5.5 | 0.14 | 0.12 |
| Comparative Example 4 | Compound 134 | BD 3 | 4.3 | 520 | 5.1 | 0.14 | 0.12 |

As can be seen from the results in Tables 1 and 2, the organic light emitting devices of Examples 1-20, which were fabricated using the novel compounds of the present invention, showed low driving voltages and high luminance and efficiency values compared to those of Comparative Examples 1-4.

## Claims

1. An organic electroluminescence device comprising a first electrode, a second electrode opposite the first electrode, and an organic layer interposed between the first electrode and the second electrode wherein the organic layer comprises a compound selected from compounds 1-5 and 7-62:

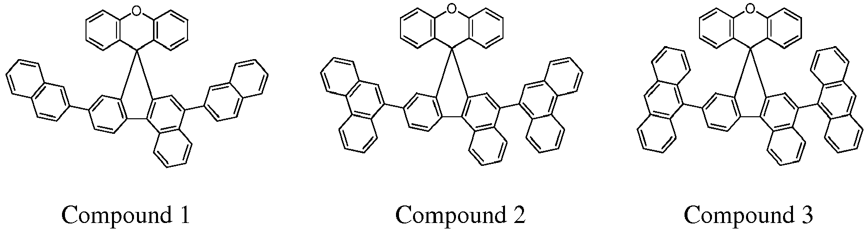

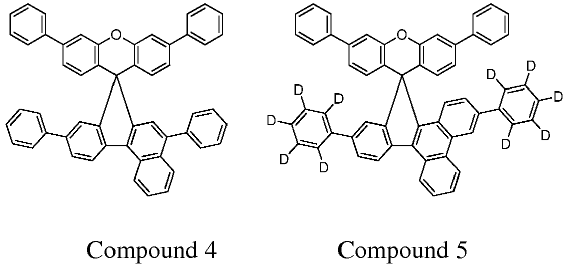

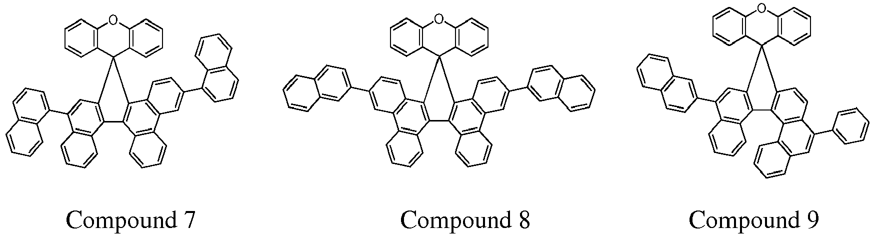

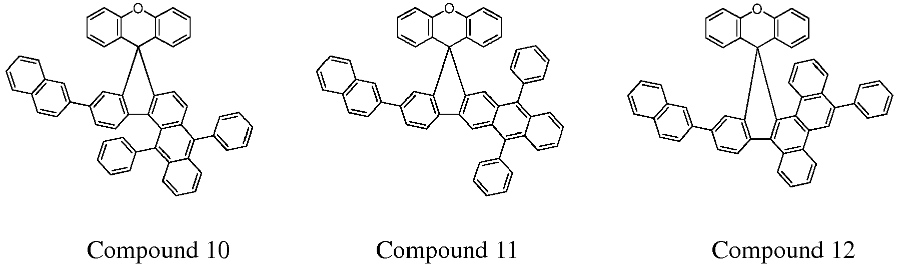

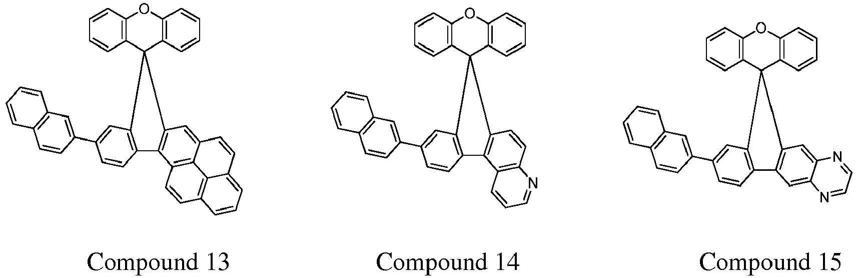

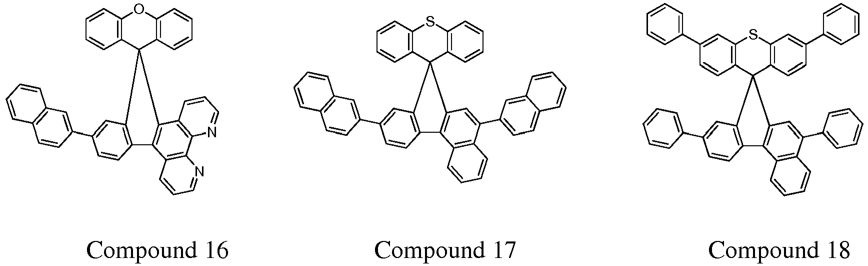

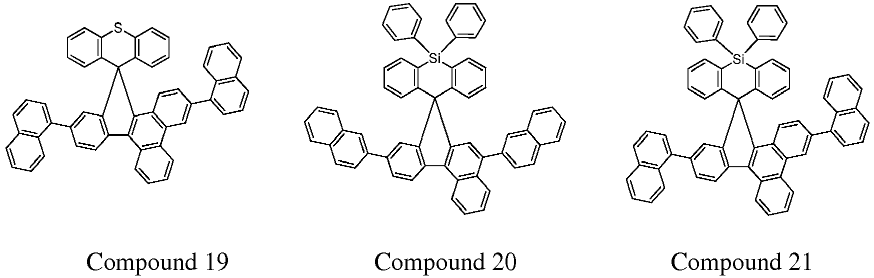

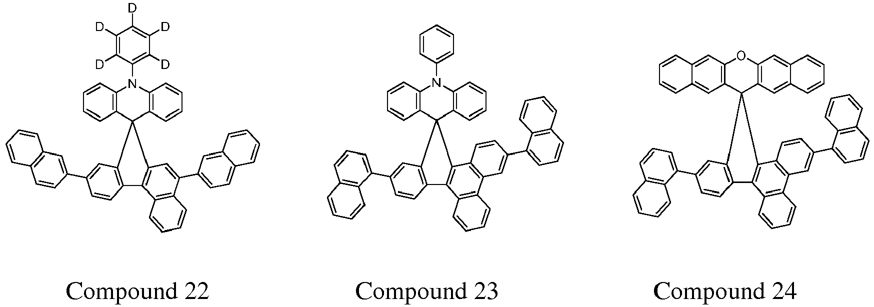

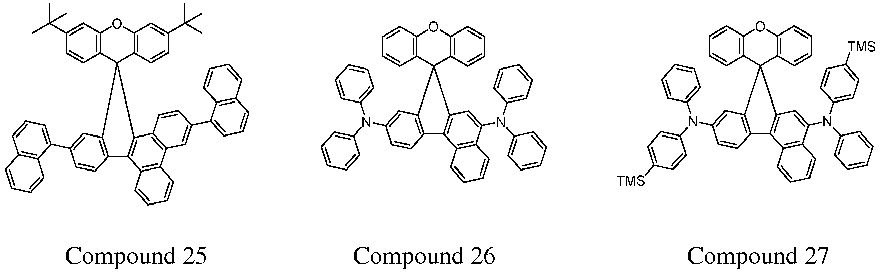

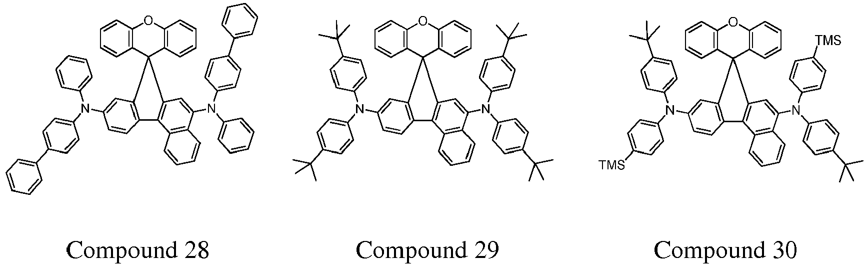

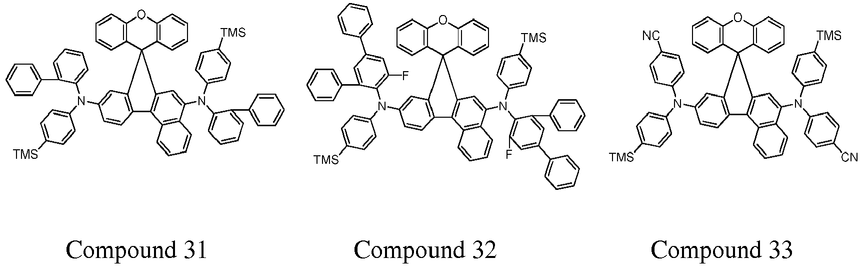

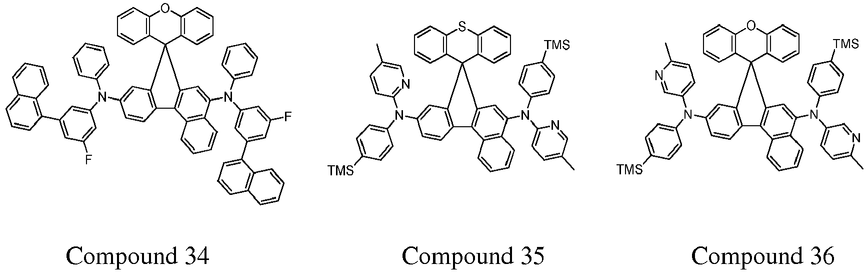

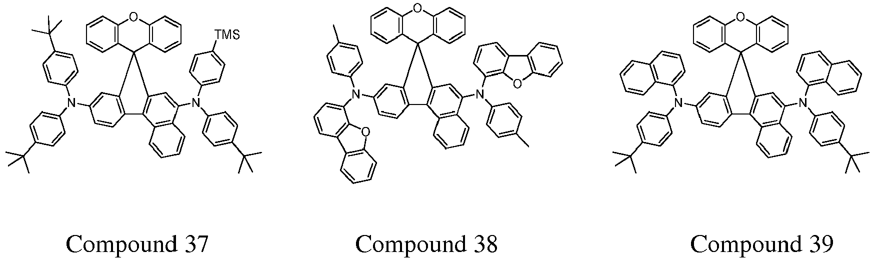

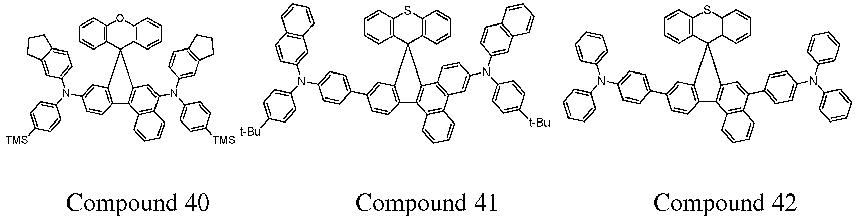

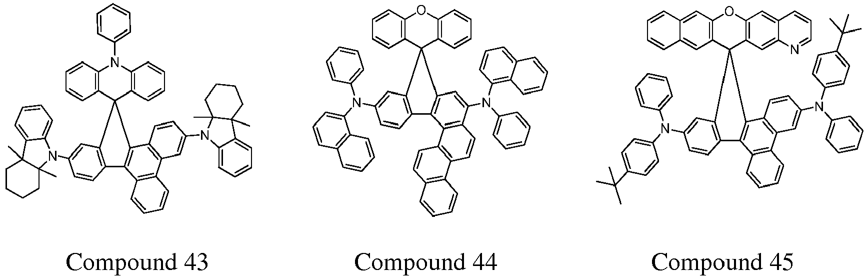

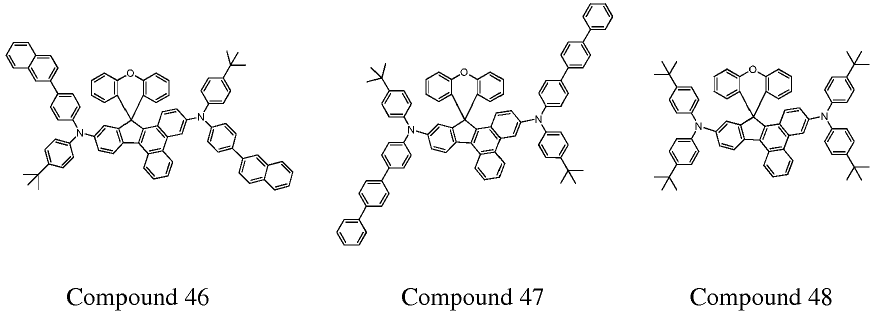

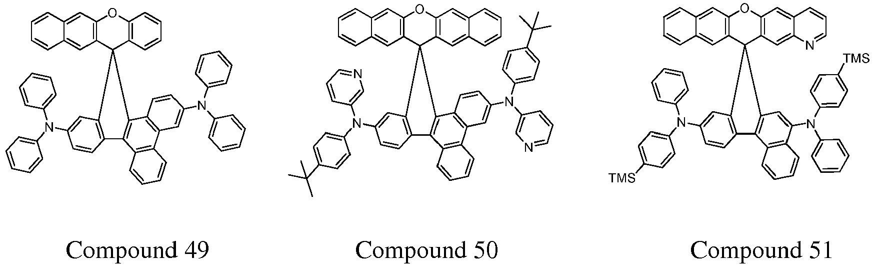

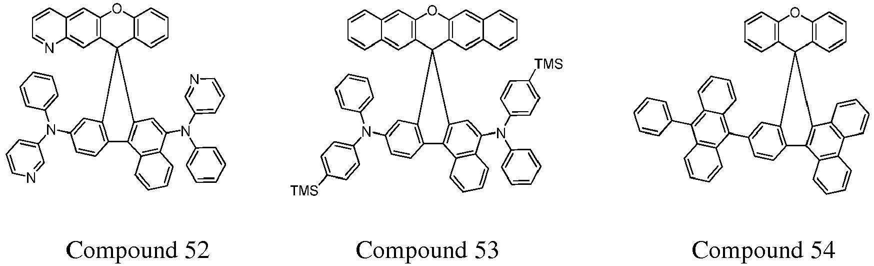

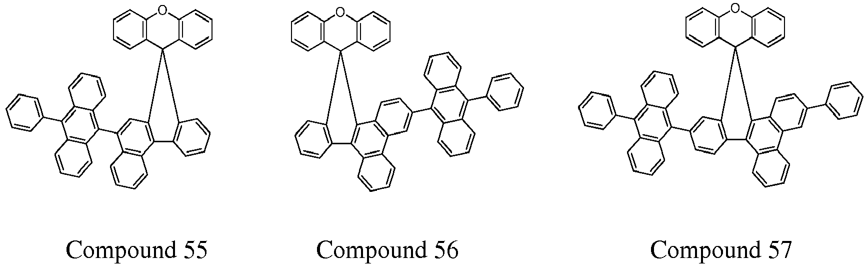

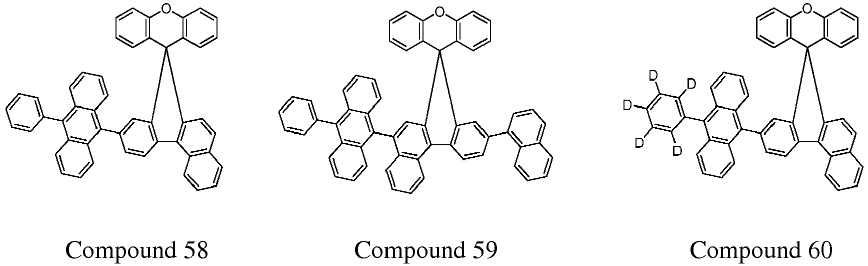

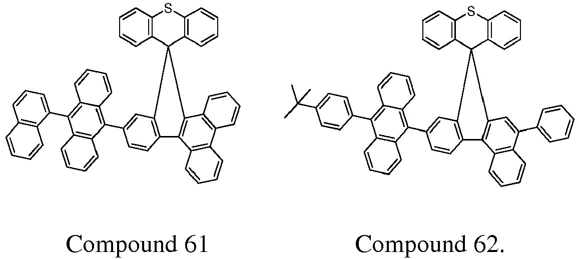

2. The organic electroluminescence device according to claim 1, wherein the organic layer comprises at least one layer selected from a hole injecting layer, a hole transport layer, a functional layer having functions of both hole injection and hole transport, a light emitting layer, an electron transport layer, an electron injecting layer, and a layer having functions of both electron transport and electron injection.

3. The organic electroluminescence device according to claim 2, wherein the light emitting layer comprises a compound selected from compounds 1-5 and 7-62 as a host compound and a compound selected from compounds 1-5 and 7-62 as a dopant compound.

4. The organic electroluminescence device according to claim 2, wherein the organic layer is formed by a deposition or solution process.

5. The organic electroluminescence device according to claim 1, wherein the organic electroluminescence device is used in a system selected from flat panel displays, flexible displays, monochromatic flat panel lighting systems, white flat panel lighting systems, flexible monochromatic lighting systems, and flexible white lighting systems.

6. The organic electroluminescence device according to claim 1, wherein the organic layer further comprises a compound represented by Formula II: 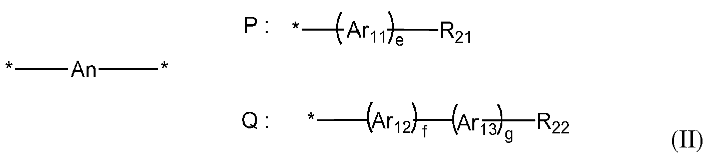 wherein An is a substituted or unsubstituted anthracene moiety, the two asterisks * indicate positions at which An is bonded to P or Q, Ar₁₁, Ar₁₂, and Ar₁₃ are identical to or different from each other and are each independently a single bond, a substituted or unsubstituted C₅-C₅₀ aromatic linking group, or a substituted or unsubstituted C₂-C₆₀ heteroaromatic linking group, R₂₁ and R₂₂ are identical to or different from each other and are each independently selected from hydrogen, deuterium, halogen atoms, hydroxyl groups, cyano groups, nitro groups, amino groups, amidino groups, hydrazine groups, hydrazone groups, carboxylic acid groups and salts thereof, sulfonic acid groups and salts thereof, phosphoric acid groups and salts thereof, substituted or unsubstituted C₁-C₆₀ alkyl groups, substituted or unsubstituted C₂-C₆₀ alkenyl groups, substituted or unsubstituted C₂-C₆₀ alkynyl groups, substituted or unsubstituted C₁-C₆₀ alkoxy groups, substituted or unsubstituted C₁-C₆₀ alkylthio groups, substituted or unsubstituted C₃-C₆₀ cycloalkyl groups, substituted or unsubstituted C₆-C₆₀ aryl groups, substituted or unsubstituted C₅-C₆₀ aryloxy groups, substituted or unsubstituted C₅-C₆₀ arylthio groups, substituted or unsubstituted C₂-C₆₀ heteroaryl groups, substituted or unsubstituted C₁-C₆₀ (alkyl)amino groups, di(substituted or unsubstituted C₁-C₆₀ alkyl)amino groups, (substituted or unsubstituted C₆-C₆₀ aryl)amino groups, di(substituted or unsubstituted C₆-C₆₀ aryl)amino groups, substituted or unsubstituted C₁-C₄₀ alkylsilyl groups, substituted or unsubstituted C₆-C₃₀ arylsilyl groups, germanium, phosphorus, and boron, each of R₂₁, R₂₂, and substituents thereof optionally forms a fused ring with the adjacent group, and e, f, and g are identical to or different from each other and are each independently an integer from 0 to 4.

7. The organic electroluminescence device according to claim 6, wherein the compound of Formula II according to the present invention is an anthracene derivative selected from Formulae II-1 to II-3: 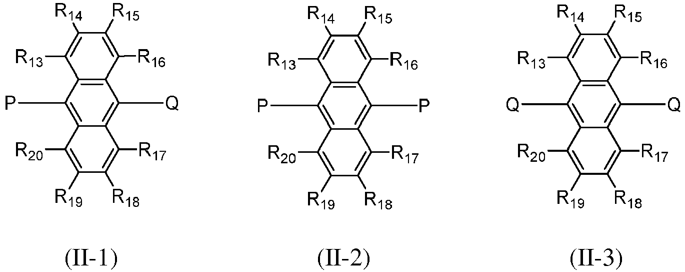 wherein R₁₃ to R₂₀ have the same meanings as R₂₁ and R₂₂ defined in Formula II, and P and Q are as defined in Formula II.

## Patentansprüche

1. Organische Elektrolumineszenzvorrichtung, umfassend eine erste Elektrode, eine zweite Elektrode gegenüber der ersten Elektrode und eine organische Schicht, eingefügt zwischen der ersten Elektrode und der zweiten Elektrode, wobei die organische Schicht eine Verbindung umfasst, ausgewählt aus den Verbindungen 1-5 und 7-62:

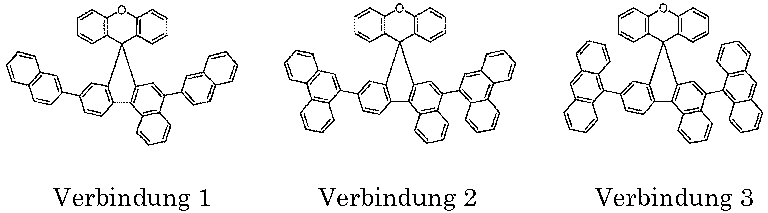

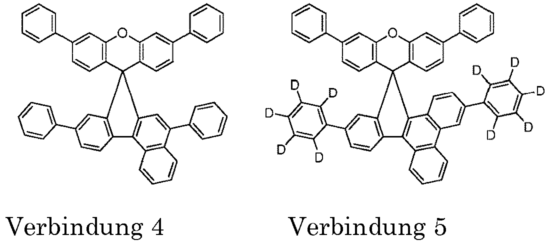

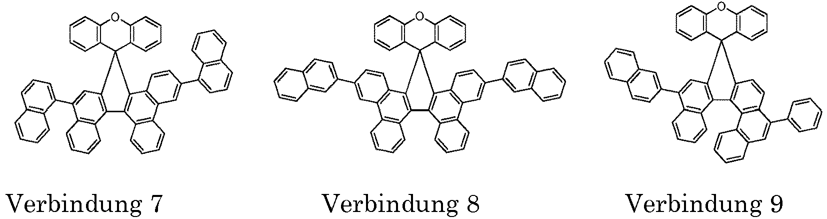

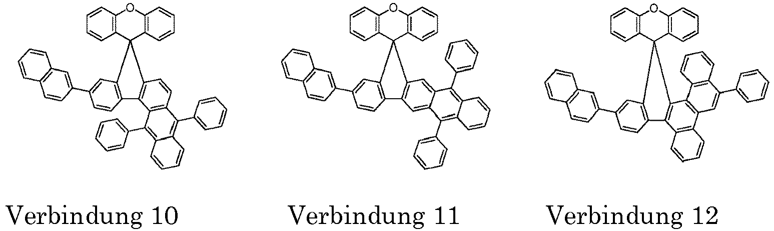

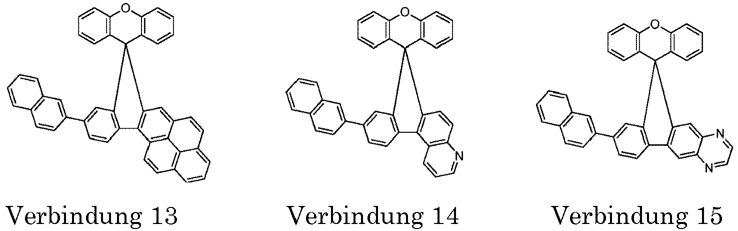

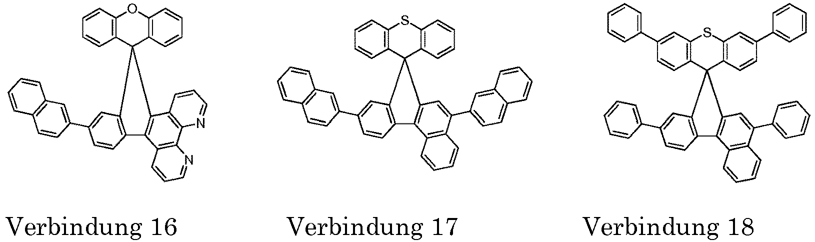

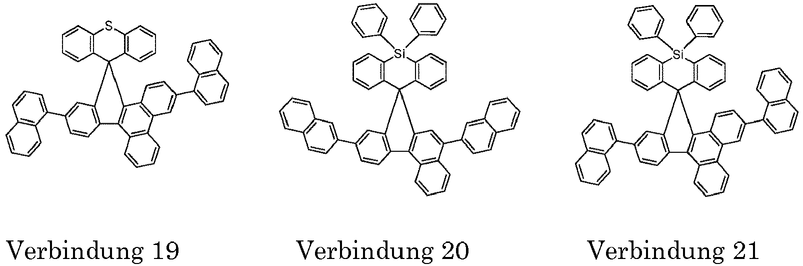

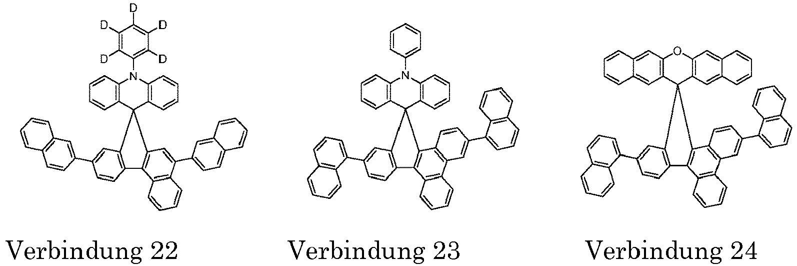

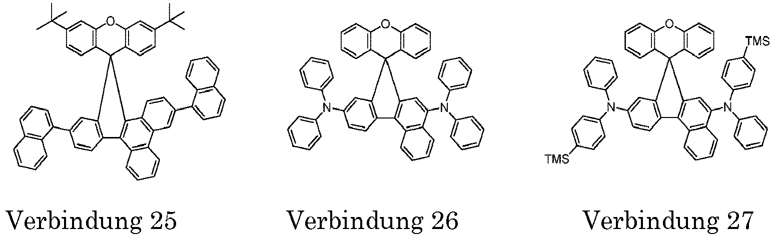

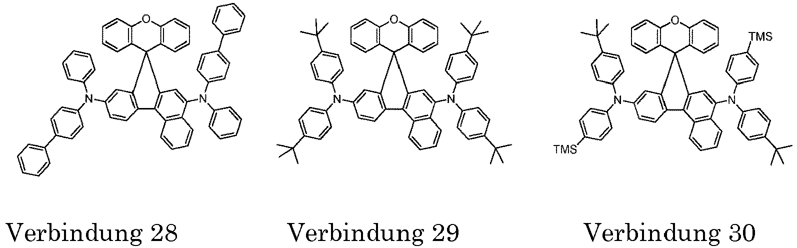

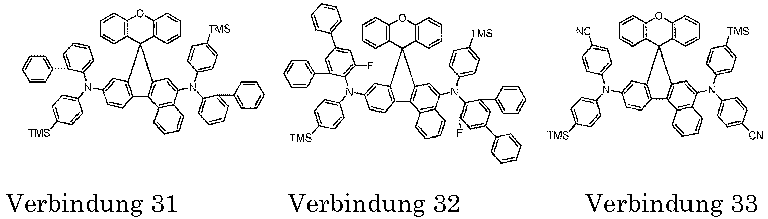

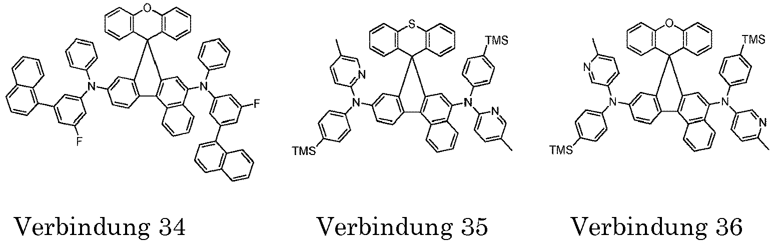

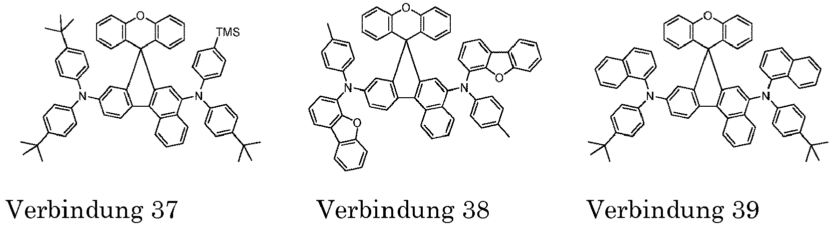

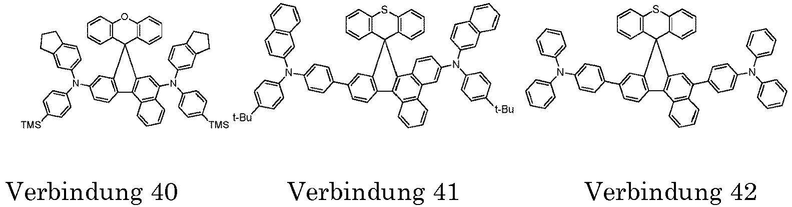

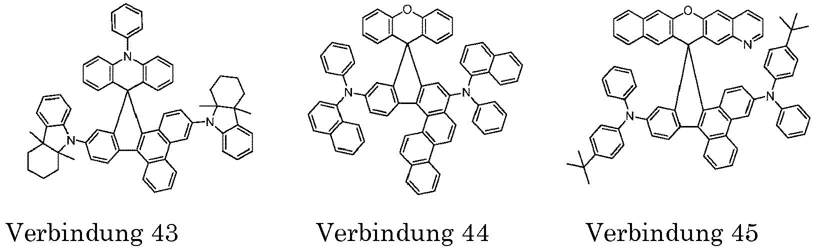

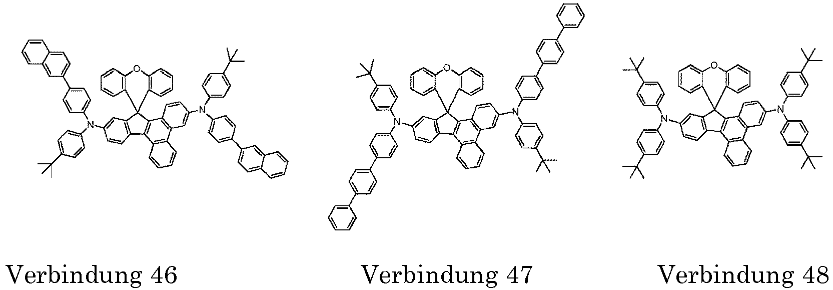

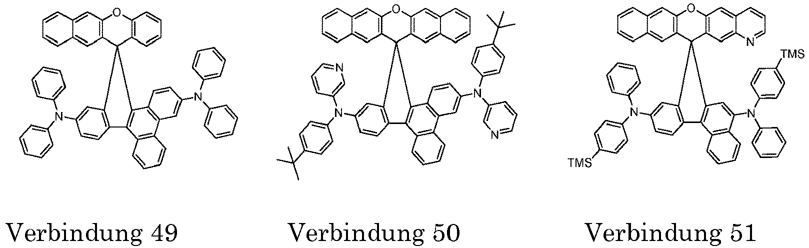

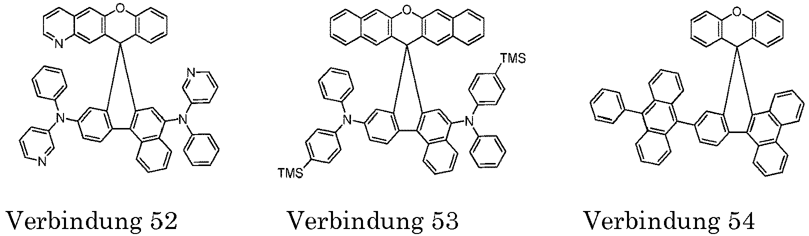

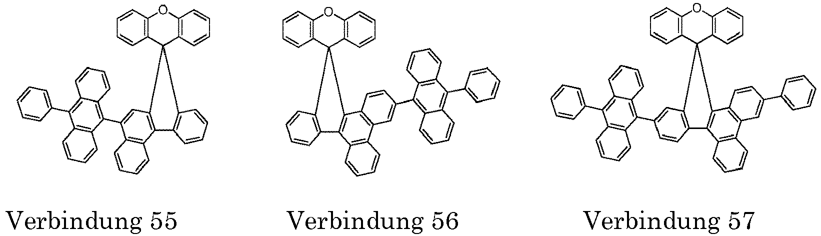

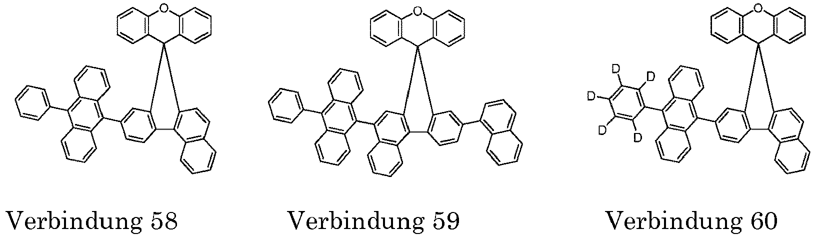

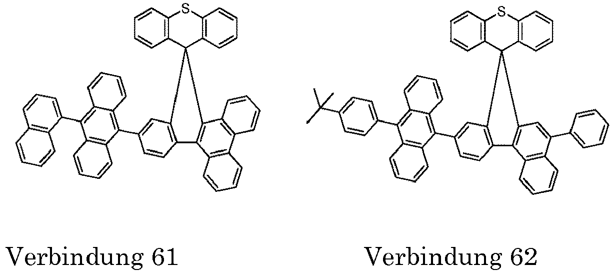

2. Organische Elektrolumineszenzvorrichtung nach Anspruch 1, wobei die organische Schicht mindestens eine Schicht umfasst, ausgewählt aus einer Lochinjektionsschicht, einer Lochtransportschicht, einer funktionalen Schicht mit Funktionen von Lochinjektion wie auch Lochtransport, einer Licht emittierenden Schicht, einer Elektronentransportschicht, einer Elektroneninjektionsschicht und einer Schicht mit Funktionen von Elektronentransport wie auch Elektroneninjektion.

3. Organische Elektrolumineszenzvorrichtung nach Anspruch 2, wobei die Licht emittierende Schicht eine Verbindung, ausgewählt aus den Verbindungen 1-5 und 7-62 als eine Wirtsverbindung, und eine Verbindung, ausgewählt aus den Verbindungen 1-5 und 7-62 als eine Dotierungsverbindung, umfasst.

4. Organische Elektrolumineszenzvorrichtung nach Anspruch 2, wobei die organische Schicht durch ein Abscheidungs- oder Lösungsverfahren gebildet wird.

5. Organische Elektrolumineszenzvorrichtung nach Anspruch 1, wobei die organische Elektrolumineszenzvorrichtung in einem System verwendet wird, ausgewählt aus Flachbildschirmen, flexiblen Bildschirmen, monochromen Flachbild-Beleuchtungssystemen, weißen Flachbild-Beleuchtungssystemen, flexiblen monochromen Beleuchtungssystemen und flexiblen weißen Beleuchtungssystemen.

6. Organische Elektrolumineszenzvorrichtung nach Anspruch 1, wobei die organische Schicht ferner eine Verbindung umfasst, dargestellt von Formel II: 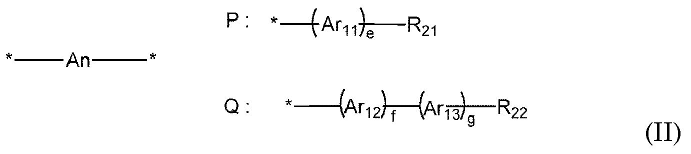 wobei An ein substituierter oder unsubstituierter Anthrazenrest ist, die zwei Sternchen * Positionen angeben, an denen An an P oder Q gebunden ist, Ar₁₁, Ar₁₂ und Ar₁₃ zueinander identisch oder voneinander verschieden sind und jeweils unabhängig eine Einzelbindung, eine substituierte oder unsubstituierte aromatische C₅-C₅₀ Vernetzungsgruppe oder eine substituierte oder unsubstituierte heteroaromatische C₂-C₆₀ Vernetzungsgruppe sind, R₂₁ und R₂₂ zueinander identisch oder voneinander verschieden sind und jeweils unabhängig ausgewählt sind aus Wasserstoff, Deuterium, Halogenatomen, Hydroxylgruppen, Cyanogruppen, Nitrogruppen, Aminogruppen, Amidinogruppen, Hydrazingruppen, Hydrazongruppen, Carboxylsäuregruppen und Salzen davon, Schwefelsäuregruppen und Salzen davon, Phosphorsäuregruppen und Salzen davon, substituierten oder unsubstituierten C₁-C₆₀ Alkylgruppen, substituierten oder unsubstituierten C₂-C₆₀ Alkenylgruppen, substituierten oder unsubstituierten C₂-C₆₀ Alkynylgruppen, substituierten oder unsubstituierten C₁-C₆₀ Alkoxygruppen, substituierten oder unsubstituierten C₁-C₆₀ Alkylthiogruppen, substituierten oder unsubstituierten C₃-C₆₀ Cycloalkylgruppen, substituierten oder unsubsttuierten C₆-C₆₀ Arylgruppen, substituierten oder unsubstituierten C₅-C₆₀ Aryloxygruppen, substituierten oder unsubstituierten C₅-C₆₀ Arylthiogruppen, substituierten oder unsubstituierten, C₂-C₆₀ Heteroarylgruppen, substituierten oder unsubstituierten C₁-C₆₀ (Alkyl)aminogruppen, di(substituierten oder unsubstituierten C₁-C₆₀ Alkyl)aminogruppen, (substituierten oder unsubstituierten C₆-C₆₀ Aryl)aminogruppen, di(substituierten oder unsubstituierten C₆-C₆₀ Aryl)aminogruppen, substituierten oder unsubstituierten C₁-C₄₀ Alkylsilylgruppen, substituierten oder unsubstituierten C₆-C₃₀ Arylsilylgruppen, Germanium, Phosphor und Boron, jedes von R₂₁, R₂₂ und Substituenten davon optional einen geschmolzenen Ring mit der angrenzenden Gruppe bildet und e, f und g miteinander identisch oder voneinander verschieden sind und jeweils unabhängig eine Ganzzahl von 0 bis 4 sind.

7. Organische Elektrolumineszenzvorrichtung nach Anspruch 6, wobei die Verbindung von Formel II nach der vorliegenden Erfindung ein Anthrazenderivat ist, ausgewählt von Formeln II-1 bis II-3: 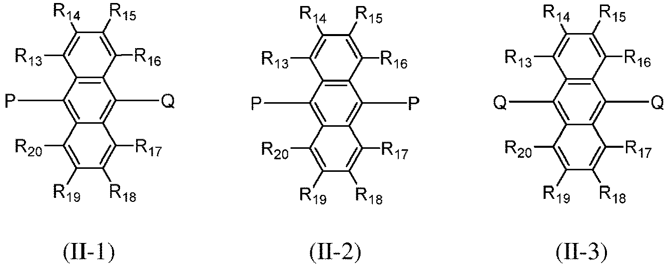 wobei R₁₃ bis R₂₀ dieselben Bedeutungen haben wie R₂₁ und R₂₂, definiert in Formel II, und P und Q wie in Formel II definiert sind.

## Revendications

1. Dispositif à électroluminescence organique comprenant une première électrode, une seconde électrode opposée à la première électrode, et une couche organique interposée entre la première électrode et la seconde électrode dans lequel la couche organique comprend un composé choisi parmi les composés 1-5 et 7-62 :

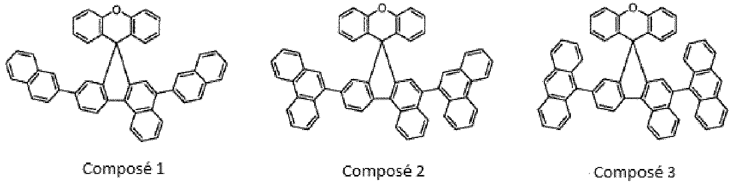

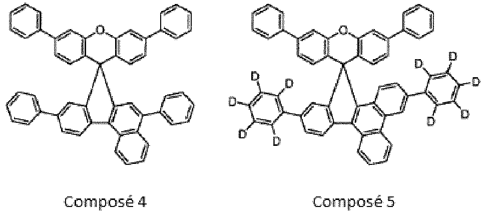

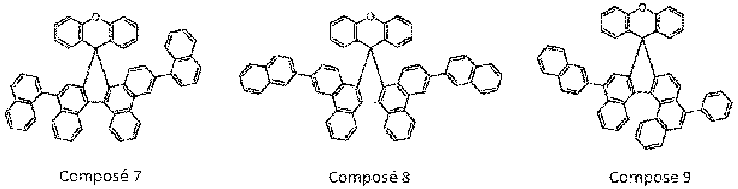

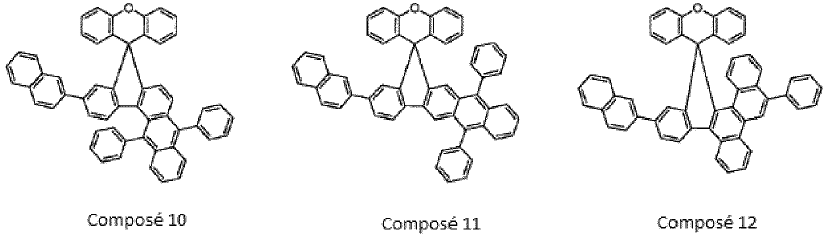

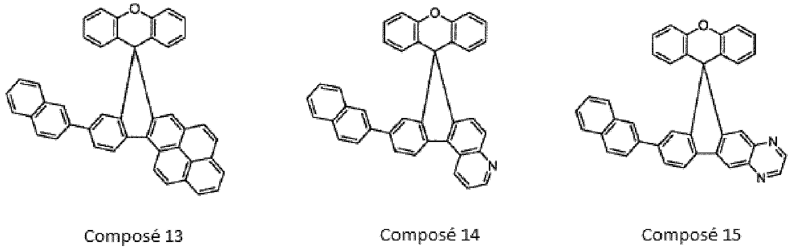

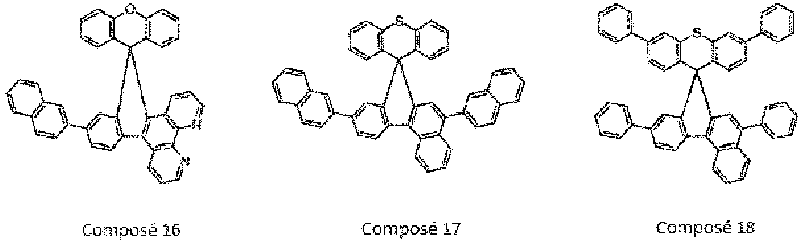

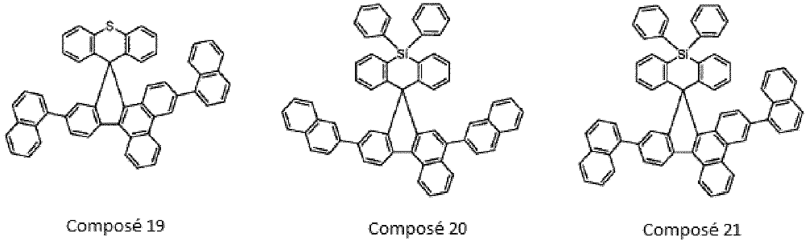

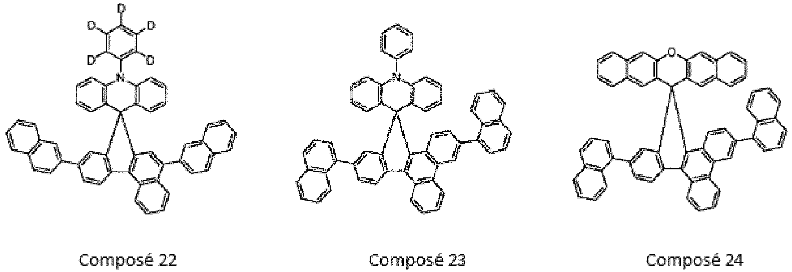

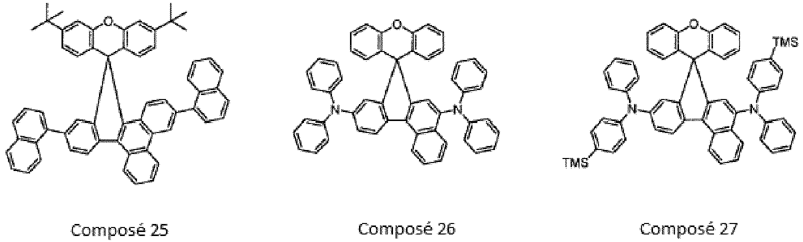

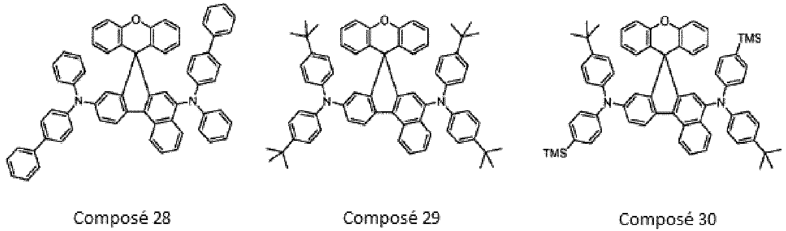

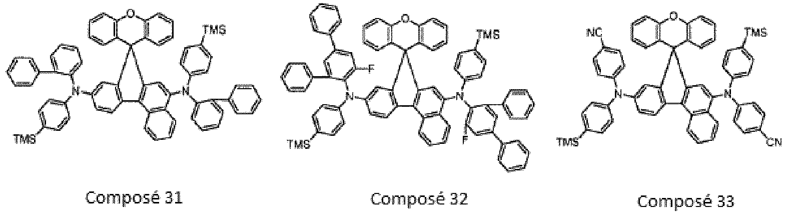

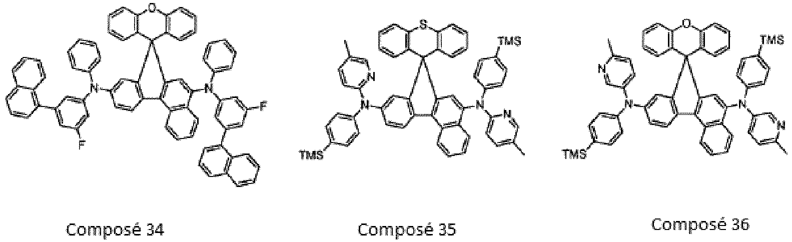

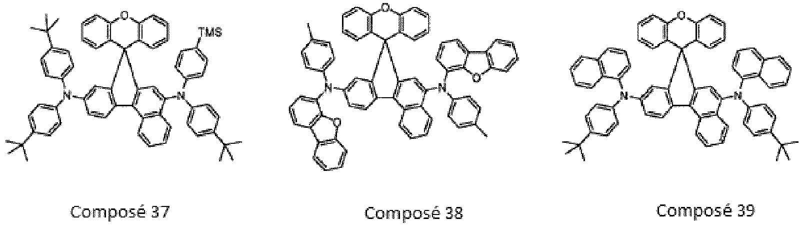

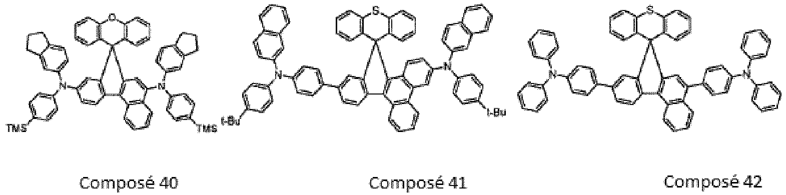

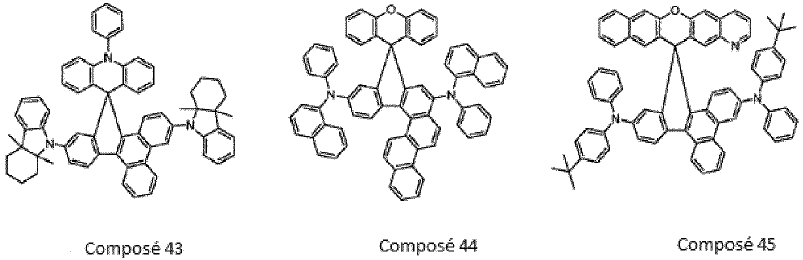

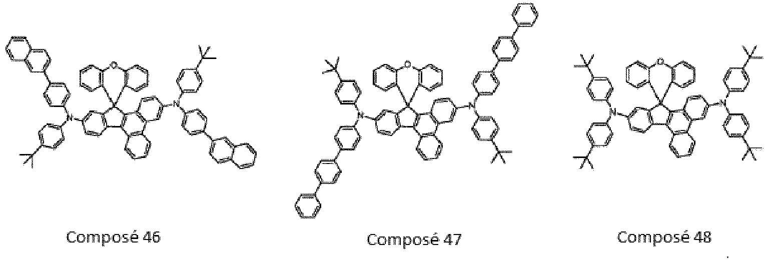

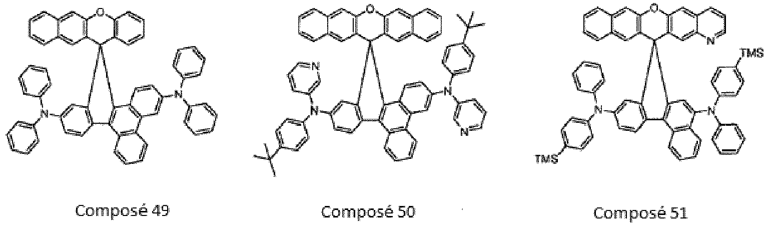

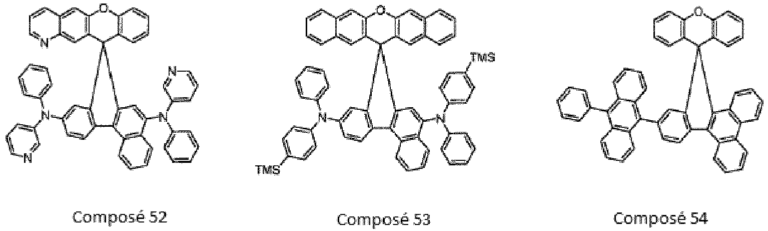

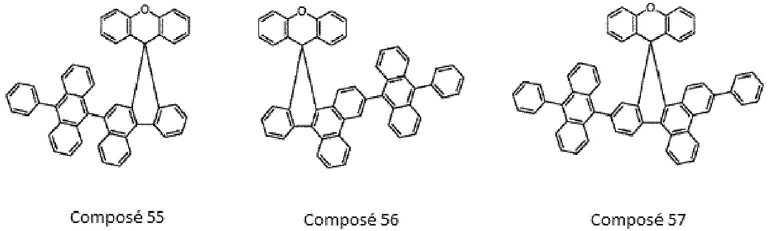

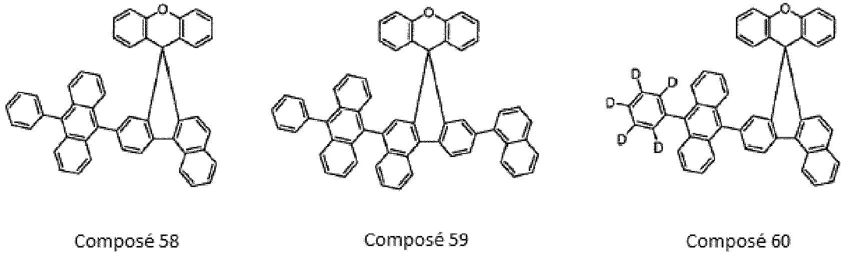

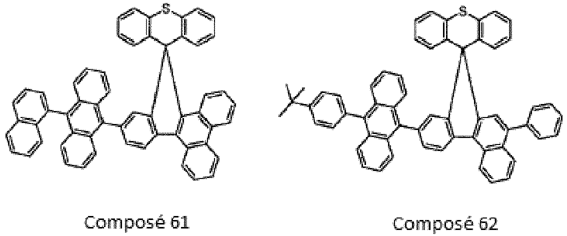

2. Dispositif à électroluminescence organique selon la revendication 1, dans lequel la couche organique comprend au moins une couche choisie parmi une couche d'injection de trous, une couche de transport de trous, une couche fonctionnelle ayant des fonctions à la fois d'injection de trous et de transport de trous, une couche émettrice de lumière, une couche de transport d'électrons, une couche d'injection d'électrons, et une couche ayant des fonctions à la fois de transport d'électrons et d'injection d'électrons.

3. Dispositif à électroluminescence organique selon la revendication 2, dans lequel la couche émettrice de lumière comprend un composé choisi parmi les composés 1-5 et 7-62 en tant que composé hôte et un composé choisi parmi les composés 1-5 et 7-62 en tant que composé dopant.

4. Dispositif à électroluminescence organique selon la revendication 2, dans lequel la couche organique est formée par un processus de dépôt ou en solution.

5. Dispositif à électroluminescence organique selon la revendication 1, dans lequel le dispositif à électroluminescence organique est utilisé dans un système choisi parmi des écrans plats, des affichages souples, des systèmes d'éclairage monochromatique à écran plat, des systèmes d'éclairage blanc à écran plat, des systèmes d'éclairage monochromatiques flexibles et des systèmes d'éclairage blanc flexibles.

6. Dispositif à électroluminescence organique selon la revendication 1, dans lequel la couche organique comprend en outre un composé représenté par la formule II : 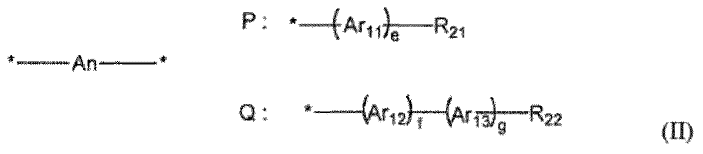 où An est un fragment d'anthracène substitué ou non substitué, les deux astérisques * indiquent des positions auxquelles An est lié à P ou Q, Ar₁₁, Ar₁₂ et Ar₁₃ sont identiques ou différents les uns des autres et sont chacun indépendamment une simple liaison, un groupe de liaison aromatique en C₅-C₅₀ substitué ou non substitué, ou un groupe de liaison hétéroaromatique en C₂-C₆₀ substitué ou non substitué, R₂₁ et R₂₂ sont identiques ou différents l'un de l'autre et sont chacun indépendamment choisis parmi de l'hydrogène, deutérium, atomes d'halogène, groupes hydroxyle, groupes cyano, groupes nitro, groupes amino, groupes amidino, groupes hydrazine, groupes hydrazone, groupes acide carboxylique et leurs sels, groupes acide sulfonique et leurs sels, groupes acide phosphorique et leurs sels, groupes alkyle en C₁-C₆₀ substitués ou non substitués, groupes alcényle en C₂₋C₆₀ substitués ou non substitués, groupes alcynyle en C₂-C₆₀ substitués ou non substitués, groupes alcoxy en C₁-C₆₀ substitués ou non substitués, groupes alkylthio en C₁-C₆₀ substitués ou non substitués, groupes cycloalkyle en C₃-C₆₀ substitués ou non substitués, groupes aryle en C₆-C₆₀ substitués ou non substitués, groupes aryloxy en C₅-C₆₀ substitués ou non substitués, groupes arylthio en C₅-C₆₀ substitués ou non substitués, groupes hétéroaryle en C₂-C₆₀ substitués ou non substitués, groupes (alkyl)amino en C₁-C₆₀ substitués ou non substitués, groupes di(alkyl en C₁-C₆₀ substitué ou non substitué)amino, des groupes (aryle en C₆-C₆₀ substitué ou non substitué)amino, groupes di(aryle en C₆-C₆₀ substitué ou non substitué)amino, groupes alkylsilyle en C₁-C₄₀ substitués ou non substitués, groupes arylsilyle en C₆-C₃₀ substitués ou non substitués, germanium, phosphore et bore, chacun des R₂₁, R₂₂, et leurs substituants forment de manière facultative un cycle fusionné avec le groupe adjacent, et e, f et g sont identiques ou sont différents les uns des autres et sont chacun indépendamment un nombre entier compris entre 0 et 4.

7. Dispositif à électroluminescence organique selon la revendication 6, dans lequel le composé ayant la formule II selon la présente invention est un dérivé d'anthracène choisi parmi les formules II-1 à II-3 : 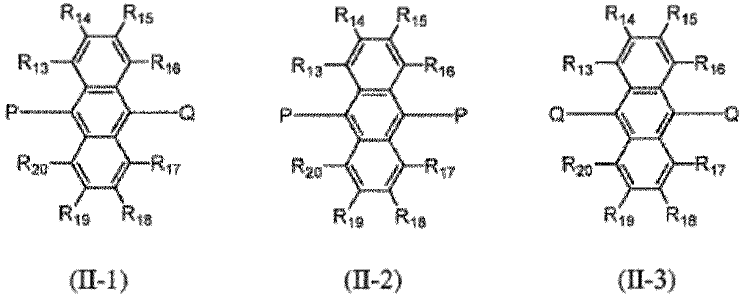 où R₁₃ à R₂₀ ont les mêmes significations que R₂₁ et R₂₂ définis dans la formule II, et P et Q sont comme défini dans la formule II.
